(19)

Europäisches Patentamt
European Patent Office
Office européen des brevets

(11) **EP 4 039 660 A1**

(12) **EUROPEAN PATENT APPLICATION**

(43) Date of publication:
**10.08.2022 Bulletin 2022/32**

(21) Application number: **22154230.1**

(22) Date of filing: **31.01.2022**

(51) International Patent Classification (IPC):
**C03C 3/06** $^{(2006.01)}$    **C03C 4/00** $^{(2006.01)}$
**C03C 23/00** $^{(2006.01)}$    **G03F 7/00** $^{(2006.01)}$
**C03B 32/00** $^{(2006.01)}$    **C03B 20/00** $^{(2006.01)}$
**C03C 17/36** $^{(2006.01)}$

(52) Cooperative Patent Classification (CPC):
**C03C 3/06; C03B 19/063; C03B 19/106;**
**C03C 4/0085; C03C 17/36; C03C 23/007;**
C03B 2201/42; C03C 2201/42

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.02.2021 US 202163147407 P**
**24.03.2021 NL 2027828**

(71) Applicant: **Corning Incorporated**
**Corning, New York 14831 (US)**

(72) Inventors:
• **Campion, Michael John**
**CORNING, 14831 (US)**
• **Hrdina, Kenneth Edward**
**CORNING, 14831 (US)**
• **Maxon, John Edward**
**CORNING, 14831 (US)**

(74) Representative: **Arnold & Siedsma**
**Bezuidenhoutseweg 57**
**2594 AC The Hague (NL)**

(54) **LOW INCLUSION TIO2-SIO2 GLASS OBTAINED BY HOT ISOSTATIC PRESSING**

(57) A silica-titania glass substrate comprising: (i) a composition comprising 5 weight percent to 10 weight percent $TiO_2$; (ii) a coefficient of thermal expansion (CTE) at 20 °C in a range from -45 ppb/K to +20 ppb/K; (iii) a crossover temperature (Tzc) in a range from 10 °C to 50 °C; (iv) a slope of CTE at 20 °C in a range from 1.20 ppb/$K^2$ to 1.75 ppb/$K^2$; (v) a refractive index variation of less than 140 ppm; and (vi) 600 ppm OH group concentration or greater. The substrate can have a mass of 1 kg or greater and 0.05 gas inclusions, or less, per 16.4 $cm^3$ (cubic inch) via a method comprising (i) forming the substrate from soot particles comprising $SiO_2$ and $TiO_2$, and (ii) subjecting the substrate to an environment having an elevated temperature and an elevated pressure for a period of time until the substrate comprises 0.05 gas inclusions, or less, per 16.4 $cm^3$ (cubic inch).

EP 4 039 660 A1

**FIG. 3**

**Description**

**Field**

This disclosure is directed to a silica-titania glass having increased $TiO_2$ homogeneity and no gas inclusions, and a method for making such glass.

**Background**

There is a trend to decrease the size of an integrated circuit (IC) like a Micro Processing Unit (MPU), Flash memory, and a Dynamic Random Access Memory (DRAM) article, while simultaneously increasing the sophistication of the circuitry of the integrated circuit. The performance of an integrated circuit increases as the feature size decreases, since a decrease in feature size allows more circuitry to be put on a chip of a given size, and reduces the power needed for operation. For example, the smaller the width of the circuitry, the more circuitry any particular integrated circuit can provide.

The use of lithographic methods allows an increased number of features at reduced size to be placed on a wafer that includes the integrated circuit. With such lithographic methods, electromagnetic radiation is directed onto a substrate that includes a layer (e.g., chromium) that is etched with the desired integrated circuit pattern. The substrate with the patterned layer is typically referred to as a photomask. The photomask image is projected (either via reflection or transmission) onto a semiconductor wafer coated with a light sensitive photoresist material.

The width of the circuitry on the integrated circuit formed by the lithographic methods is thus related to the wavelength of the electromagnetic radiation utilized to project the integrated circuit pattern from the photomask onto the semiconductor wafer. In the late 1990s, the semiconductor industry was using KrF lasers to generate electromagnetic radiation having a 248 nanometer ("nm") wavelength to print 120 nm to 150 nm features on the substrate. Later, some lithographic systems used ArF lasers to generate electromagnetic radiation having a wavelength of 193 nm to print linewidths as small as 50 nm on the substrate. In addition, there may have been attempts to use $F_2$ lasers to generate electromagnetic radiation having a wavelength of 157 nm to print smaller linewidths. At these wavelengths, the photomask could be optically transmissive (rather than reflective), such as with a substrate of high purity fused silica or Group IIA alkaline earth metal fluorides (e.g., calcium fluoride).

Now, lithographic systems using electromagnetic radiation having a wavelength of 120 nm or less, such as in the range of 11 nm to 15 nm (sometimes referred to as "extreme ultraviolet" or "EUV"), are emerging to print linewidths as small as 22 nm. However, materials used for the 248 nm, 193 nm, and 157 nm lithographic systems absorb radiation in the EUV range instead of transmitting it. As a result, reflective optics (i.e., mirrors) must be used instead of conventional focusing optics, and reflective photomasks instead of transmissive photomasks must be used. In a typical EUVL system, a condenser system including mirrors collects, shapes, and filters radiation from the source of the EUV electromagnetic radiation to achieve a highly uniform intense beam. The beam is then projected onto the photomask containing a pattern to be replicated onto a silicon wafer. The pattern is reflected into a reduction imaging system including an assembly of reflective mirrors. The reflective mirrors image the photomask pattern and focus the photomask pattern onto the photoresist coating on the silicon wafer.

The smaller the wavelength of the electromagnetic radiation, the greater the number of mirrors that are needed to maintain the required resolution or the electromagnetic radiation. The increased number of mirrors causes a loss of intensity of the electromagnetic radiation due to scattering. To compensate, higher energy sources to generate the electromagnetic radiation could be used (e.g., 100 W instead of 5 W). However, the higher energy sources cause the photomask and other optical elements, such as the mirrors, to experience elevated temperatures (e.g., ~80 °C).

Because of the temperature changes involved with EUV lithographic systems, the expansion/contraction properties of the reflective optics and the photomask must be carefully controlled. In particular, it is critically important that the coefficient of thermal expansion ("CTE") be kept as low as possible, and that the rate of change of the CTE as a function of temperature ("slope of CTE") be as low as possible in the normal operating temperature range of the lithographic process, which is in a general range of 4 °C to 40 °C, preferably 20 °C to 25 °C, with approximately 22 °C being the target temperature. In addition, because the wavelengths of the electromagnetic radiation in EUV systems are so short, any irregularity present on the surface of the reflective optics or photomask will significantly degrade system performance. Thus, the substrate used to produce the reflective optics and the photomask must be of the highest quality.

One material that has a suitable CTE and slope of CTE for use as the substrate for reflectance optics and photomasks for EUV lithographic systems is silica-titania glass. An example silica-titania glass is ULE® (Corning Incorporated, Corning, N.Y.), which is a single-phase glass material.

In one conventional method, a flame hydrolysis process forms the silica-titania glass. A mixture of silica precursor and a very pure titania precursor (e.g., octamethylcyclotetrasiloxane and titanium isopropoxide) are delivered in vapor form to a flame to form $SiO_2$-$TiO_2$ soot particles. The soot particles melt in layers into a solid silica-titania optical blank.

This is sometimes referred to as a "direct-to-glass" process. This process produces large boules of the glass.

However, that method causes the formation of striae in the optical blank. Striae are periodic inhomogeneities in the glass which adversely affect many properties of the substrate. Striae result from thermal variations in the flame during the formation of the fine particles, and are also a result of thermal variations of the growing glass as the fine particles are deposited. Striae result in alternating thin layers of different CTE and therefore alternating planes of compression and tension between the layers. Striae in ULE glass are evident in the direction parallel with the top and bottom of the glass.

In some cases, striae have been found to impact surface finish at an angstrom root mean square (rms) level in reflective optical elements, which can adversely affect the polishability of the glass. Polishing glass having striae results in unequal material removal and unacceptable surface roughness, which can present problems for stringent applications like EUV lithography elements. For example, it may create a mid-frequency surface structure that may cause image degradation in mirrors used in the projection systems for EUV lithography.

Another problem encountered is low frequency inhomogeneity, which causes a phenomenon known as springback. Springback refers to the shape change of a glass object with a non-uniform CTE. The change in shape typically occurs upon removal of material from the glass object. Further, the striae cause an inhomogeneity in thermal expansion in the substrate, causing reflective optics made therefrom to have less than optimal thermal properties. The striae also cause optical inhomogeneities, which make the substrate unsuitable for use in many optical transmission elements (e.g., lenses, windows, prisms).

A further problem is a lack of long-scale uniformity in $TiO_2$ concentration across the length of the substrate produced by this "direct-to-glass" process. The lack of long-scale uniformity in $TiO_2$ concentration is thought to be a consequence of the use of multiple burners.

Another drawback relates to the presence of gas inclusions within the substrate. Like striae, gas inclusions negatively affect polishing of the substrate, distort the surfaces of the substrate, and interfere with inspection of the substrate, which is typically performed with a laser.

Therefore, there is a need for a method of producing silica-titania glass that not only has a suitable CTE, slope of CTE, and other material properties for use in EUV applications, but additionally lacks striae and gas inclusions.

## SUMMARY

The present disclosure addresses that need by producing loose soot particles comprising $SiO_2$ and $TiO_2$, pressing the loose soot particles into a substrate, and then subjecting the substrate to a high temperature and high pressure environment in a hot isostatic step. Pressing the loose soot particles into the substrate imbues the substrate with a high degree of compositional homogeneity, which prevents appreciable striae formation. Before the substrate is subjected to the high pressure and high temperature environment, the substrate may have a high degree of gas inclusions. However, subjecting the substrate to the high temperature and high pressure environment causes the gas inclusions to collapse. The resulting substrate has very low gas inclusions. In addition, the resulting substrate has material properties suitable for EUV applications, including a desirable CTE, slope of CTE, crossover temperature, OH group concentration, and hardness, especially after further annealing the substrate. The substrate can then be sliced to form a plurality of substrates sized for EUV lithography applications, such as mirrors and photomasks.

According to a first aspect of the present disclosure, a silica-titania glass substrate comprises: (i) a composition comprising 5 weight percent to 10 weight percent $TiO_2$; (ii) a coefficient of thermal expansion (CTE) at 20 °C of -45 ppb/K to +20 ppb/K; (iii) a crossover temperature (Tzc) of 10 °C to 50 °C; (iv) a slope of CTE at 20 °C of 1.20 ppb/$K^2$ to 1.75 ppb/$K^2$; (v) a refractive index variation of 140 ppm, or less,; and (vi) a concentration of OH groups of 600 ppm or greater.

According to a second aspect of the disclosure, the silica-titania glass substrate of the first aspect further comprises: (i) a mass of 1 kg or greater; and (ii) 0.05 gas inclusions, or less, per 16.4 $cm^3$ (per cubic inch).

According to a third aspect of the disclosure, the silica-titania glass substrate of the first aspect further comprises: (i) a mass of 100 grams to 1 kg; and (ii) 0.05 gas inclusions, or less, per 16.4 $cm^3$ (per cubic inch).

According to a fourth aspect of the disclosure, the silica-titania glass substrate of any one of the first through third aspects further comprises 0.02 gas inclusions, or less, per 16.4 $cm^3$ (cubic inch).

According to a fifth aspect of the disclosure, the silica-titania glass substrate of any one of the first through fourth aspects further comprises no gas inclusions.

According to a sixth aspect of the disclosure, the silica-titania glass substrate of any one of the first through fifth aspects, wherein the composition further comprises 0.001 to 0.01 weight percent carbon.

According to a seventh aspect of the disclosure, the silica-titania glass substrate of any one of the first through sixth aspects further comprising one or more solid inclusions that comprise one or more of iron, chromium, zirconium, an oxide of iron, an oxide of chromium, an oxide of zirconium, and cristobalite.

According to an eighth aspect of the disclosure, the silica-titania glass substrate of any one of the first through seventh aspects further comprising a hardness in a range from 4.60 GPa to 4.75 GPa.

According to a ninth aspect of the disclosure, the silica-titania glass substrate of any one of the first through eighth aspects, wherein the crossover temperature (Tzc) is in a range from 20 °C to 38 °C.

According to a tenth aspect of the disclosure, the silica-titania glass substrate of any one of the first through ninth aspects, wherein the crossover temperature (Tzc) is in a range from 22 °C to 38 °C.

According to an eleventh aspect of the disclosure, the silica-titania glass substrate of any one of the first through tenth aspects, wherein the slope of CTE at 20 °C is in a range from 1.30 ppb/$K^2$ to 1.65 ppb/$K^2$.

According to a twelfth aspect of the disclosure, the silica-titania glass substrate of any one of the first through eleventh aspects, wherein the refractive index variation is 60 ppm, or less.

According to a thirteenth aspect of the disclosure, the silica-titania glass substrate of any one of the first through twelfth aspects, wherein the refractive index variation is in a range from 20 ppm to 60 ppm.

According to a fourteenth aspect of the disclosure, the silica-titania glass substrate of any one of the first through thirteenth aspects, wherein the concentration of OH groups is in a range from 600 ppm to 1400 ppm.

According to a fifteenth aspect of the disclosure, the silica-titania glass substrate of any one of the first through fourteenth aspects, wherein the concentration of OH groups is in a range from 700 ppm to 1200 ppm.

According to a sixteenth aspect of the disclosure, a method comprises: subjecting a substrate (i) formed from soot particles, each of the soot particles comprising $SiO_2$ and $TiO_2$, and (ii) comprising greater than or equal to 0.05 gas inclusions per 16.4 $cm^3$ (cubic inch), to an environment having an elevated temperature and an elevated pressure for a period of time until the substrate comprises 0.05 gas inclusions, or less, per 16.4 $cm^3$ (cubic inch).

According to a seventeenth aspect of the disclosure, the method of the sixteenth aspect further comprises: before subjecting the substrate to the environment, (i) forming the soot particles as loose soot particles, and (ii) collecting the soot particles.

According to a eighteenth aspect of the disclosure, the method of any one of the sixteenth through seventeenth aspects further comprises: before subjecting the substrate to the environment, (i) molding the soot particles at room temperature into a molded precursor substrate having a predetermined density in a range from 0.50 $g/cm^3$ to 1.20 $g/cm^3$, and (ii) heat treating the molded precursor substrate in the presence of steam, forming the substrate; wherein, the substrate is opaque following the step of heat treating the molded precursor substrate.

According to a nineteenth aspect of the disclosure, the method of any one of the sixteenth through seventeenth aspects further comprises: before subjecting the substrate to the environment, (i) molding the soot particles at room temperature into a molded precursor substrate having a predetermined density in a range from 0.50 $g/cm^3$ to 1.20 $g/cm^3$, (ii) heat treating the molded precursor substrate in the presence of steam, thus forming a consolidated molded precursor substrate, and (iii) melting the consolidated precursor substrate into a melt that flows into a mold, thus, upon subsequent cooling, forms the substrate; wherein, the elevated temperature of the environment of the subjecting step is in a range from 1000 °C to 1150 °C.

According to a twentieth aspect of the disclosure, the method of any one of the eighteenth through nineteenth aspects, wherein heat treating the molded precursor substrate in the presence of steam comprises subjecting the molded precursor substrate to a consolidation environment into which steam is introduced to achieve a pressure within the consolidation environment in a range from 0.1 atm to 10 atm.

According to a twenty-first aspect of the disclosure, the method of any one of the sixteenth through twentieth aspects further comprises: after subjecting the substrate to the environment, annealing the substrate for at least 100 hours with a maximum temperature in a range from 900 °C to 1200 °C.

According to a twenty-second aspect of the disclosure, the method of any one of the sixteenth through twenty-first aspects further comprising: after subjecting the substrate to the environment, slicing the substrate into a plurality of substrates, each of the plurality of substrates having a mass in a range from 100 grams to 1 kg.

According to a twenty-third aspect of the disclosure, the method of the twenty-second aspect, wherein each of the plurality of substrates comprises 0.01 gas inclusions, or less, per 16.4 $cm^3$ (cubic inch).

According to a twenty-fourth aspect of the disclosure, the method of the twenty-second aspect, wherein each of the plurality of substrates comprises no gas inclusions.

According to a twenty-fifth aspect of the disclosure, the method of any one of the twenty-second through twenty-fourth aspects further comprising: applying a reflective multilayer film on at least one of the plurality of substrates; and forming an absorber on the reflective multilayer film.

According to a twenty-sixth aspect of the disclosure, the method of any one of the sixteenth through twenty-fifth aspects, wherein, before subjecting the substrate to the environment, the gas inclusions comprise one or more of CO and $CO_2$.

According to a twenty-seventh aspect of the disclosure, the method of the twenty-sixth aspect, wherein, before subjecting the substrate to the environment, the gas inclusions comprise at least 70 mole percent combined of CO and $CO_2$.

According to a twenty-eighth aspect of the disclosure, the method of any one of the sixteenth through twenty-seventh aspects, wherein the environment having the elevated temperature and the elevated pressure comprises an inert gas.

According to a twenty-ninth aspect of the disclosure, the method of any one of the sixteenth through twenty-eighth aspects, wherein the elevated temperature is in a range from 1000 °C to 1800 °C.

According to a thirtieth aspect of the disclosure, the method of any one of the sixteenth through twenty-ninth aspects, wherein the elevated pressure is in a range from 3447.4 kPa to 103421.4 kPa (0.5 kpsi to 15 kpsi).

According to a thirty-first aspect of the disclosure, the method of any one of the sixteenth through thirtieth aspects, wherein the period of time is at least 1 hour.

According to a thirty-second aspect of the disclosure, the method of any one of the sixteenth through thirty-first aspects, wherein before the period of time begins and while the substrate is in the environment, a temperature of the environment is increased from room temperature to the elevated temperature at a temperature increase rate in a range from 125 °C/hr to 500 °C/hr.

According to a thirty-third aspect of the disclosure, the method of any one of the sixteenth through thirty-second aspects, wherein after the period of time ends and while the substrate is in the environment, the temperature of the environment is decreased from the elevated temperature to room temperature at a temperature decrease rate in a range from 125 °C/hr to 500 °C/hr.

According to a thirty-fourth aspect of the disclosure, the method of any one of the sixteenth through thirty-third aspects, wherein (i) the elevated pressure is in a range from 8963.2 kPa to 11721.1 kPa (1.3 kpsi to 1.7 kpsi); (ii) the elevated temperature is in a range from 1650 °C to 1800 °C; (iii) the period of time is in a range from 8 hours to 12 hours; (iv) before the period of time begins and while the substrate is in the environment, a temperature of the environment is increased from room temperature to the elevated temperature at a temperature increase rate in a range from 250 °C/hr to 350 °C/hr; and (v) after the period of time ends and while the substrate is in the environment, the temperature of the environment is decreased from the elevated temperature to room temperature at a temperature decrease rate in a range from 250 °C/hr to 350 °C/hr.

According to a thirty-fifth aspect of the disclosure, the method of any one of the sixteenth through thirty-fourth aspects, wherein during the subjecting the substrate to the environment, a support comprising graphite supports the substrate.

According to a thirty-sixth aspect of the disclosure, the method of any one of the sixteenth through thirty-fifth aspects, wherein after subjecting the substrate to the environment, the substrate comprises: (i) a composition comprising 5 weight percent to 10 weight percent $TiO_2$; (ii) a coefficient of thermal expansion (CTE) at 20 °C in a range from -45 ppb/K to +20 ppb/K; (iii) a crossover temperature (Tzc) in a range from 10 °C to 50 °C; (iv) a slope of CTE at 20 °C in a range from 1.20 $ppb/K^2$ to 1.75 $ppb/K^2$; (v) a refractive index variation of 140 ppm, or less,; and (vi) a concentration of OH groups of 600 ppm or greater.

According to a thirty-seventh aspect of the disclosure, the method of any one of the sixteenth through thirty-sixth aspects, wherein after subjecting the substrate to the environment, the substrate comprises a hardness in a range from 4.60 GPa to 4.75 GPa.

According to a thirty-eighth aspect of the disclosure, the method of any one of the sixteenth through thirty-seventh aspects, wherein (i) the crossover temperature (Tzc) is in a range from 20 °C to 38 °C; (ii) the slope of CTE at 20 °C is in a range from 1.30 $ppb/K^2$ to 1.65 $ppb/K^2$; (iii) the refractive index variation is in a range from 20 ppm to 60 ppm; and (iv) the concentration of OH groups is in a range from 600 ppm to 1400 ppm.

According to a thirty-ninth aspect of the disclosure, the method of any one of the sixteenth through twenty-first and twenty-sixth through thirty-eighth aspects, wherein the substrate further comprises a mass of 1 kg or greater; and after subjecting the substrate to the environment, the substrate further comprises 0.01 gas inclusions, or less, per 16.4 $cm^3$ (cubic inch).

According to a fortieth aspect of the disclosure, the method of the thirty-ninth aspect, wherein after subjecting the substrate to the environment, the substrate further comprises no gas inclusions.

According to a forty-first aspect of the disclosure, any one of the sixteenth through twenty-first and twenty-sixth through fortieth aspects further comprising: applying a reflective multilayer film on the substrate; and forming an absorber on the reflective multilayer film.

According to a forty-second aspect of the disclosure, a method comprises: (i) forming soot particles comprising $SiO_2$ and $TiO_2$ as loose soot particles; (ii) collecting the soot particles; (iii) molding the soot particles into a molded precursor substrate; (iv) heat treating the molded precursor substrate in the presence of steam, forming a substrate, the substrate comprising greater than or equal to 0.05 gas inclusions per 16.4 $cm^3$ (per cubic inch); and (v) subjecting the substrate to an environment having an elevated temperature in a range from 1000 °C to 1800 °C and an elevated pressure in a range from 3447.4 kPa to 103421.4 kPa (0.5 kpsi to 15 kpsi) for a period of time in a range from 1 hour to 120 hours until the number of the gas inclusions per cubic inch has reduced to 0.05 gas inclusions, or less, per 16.4 $cm^3$ (cubic inch).

According to a forty-third aspect of the disclosure, the method of the forty-second aspect, wherein (i) before the predetermined period of time begins, a temperature of the environment is increased from room temperature to the elevated temperature in the presence of the substrate at a temperature increase in a range from 125 °C/hr to 500 °C/hr; and (ii) after the predetermined period of time ends, the temperature of the environment is decreased from the elevated temperature to room temperature in the presence of the substrate at a temperature decrease rate in a range from 125 °C/hr to 500 °C/hr.

According to a forty-fourth aspect of the disclosure, the method of any one of the forty-second through forty-third aspects, wherein after the substrate is subjected to the environment, the substrate comprises: (i) a composition comprising 5 weight percent to 10 weight percent $TiO_2$; (ii) a coefficient of thermal expansion (CTE) at 20 °C in a range from -45 ppb/K to +20 ppb/K; (iii) a crossover temperature (Tzc) in a range from 10 °C to 50 °C; (iv) a slope of CTE at 20 °C in a range from 1.20 ppb/$K^2$ to 1.75 ppb/$K^2$; (v) a refractive index variation of 140 ppm or less; (vi) a concentration of OH groups of 600 ppm or greater; and (vii) a hardness in a range from 4.60 GPa to 4.75 GPa.

The disclosure also includes the following clauses:

Clause 1. A silica-titania glass substrate comprising:

a composition comprising 5 weight percent to 10 weight percent $TiO_2$;
a coefficient of thermal expansion (CTE) at 20 °C in a range from -45 ppb/K to +20 ppb/K;
a crossover temperature (Tzc) in a range from 10 °C to 50 °C;
a slope of CTE at 20 °C in a range from 1.20 ppb/K2 to 1.75 ppb/K2;
a refractive index variation of 140 ppm or less; and
a concentration of OH groups of 600 ppm or greater.

Clause 2. The silica-titania glass substrate of clause 1 further comprising:

a mass of 1 kg or greater; and
0.05 gas inclusions, or less, per 16.4 $cm^3$ (cubic inch).

Clause 3. The silica-titania glass substrate of clause 1 further comprising:

a mass in a range from 100 grams to 1 kg; and
0.05 gas inclusions, or less, per 16.4 $cm^3$ (cubic inch).

Clause 4. The silica-titania glass substrate of any one of clauses 1-3, further comprising 0.01 gas inclusions, or less, per 16.4 $cm^3$ (cubic inch).

Clause 5. The silica-titania glass substrate of any one of clauses 1-3, further comprising no gas inclusions.

Clause 6. The silica-titania glass substrate of any one of clauses 1-5, wherein the composition further comprises 0.001 to 0.01 weight percent carbon.

Clause 7. The silica-titania glass substrate of any one of clauses 1-6, further comprising one or more solid inclusions that comprise one or more of iron, chromium, zirconium, an oxide of iron, an oxide of chromium, an oxide of zirconium, and cristobalite.

Clause 8. The silica-titania glass substrate of any one of clauses 1-7, further comprising a hardness in a range from 4.60 GPa to 4.75 GPa.

Clause 9. The silica-titania glass substrate of any one of clauses 1-8, wherein the crossover temperature (Tzc) is in a range from 20 °C to 38 °C.

Clause 10. The silica-titania glass substrate of any one of clauses 1-9, wherein the crossover temperature (Tzc) is in a range from 22 °C to 38 °C.

Clause 11. The silica-titania glass substrate of any one of clauses 1-10, wherein the slope of CTE at 20 °C is in a range from 1.30 ppb/K2 to 1.65 ppb/K2.

Clause 12. The silica-titania glass substrate of any one of clauses 1-11, wherein the refractive index variation is 60 ppm, or less.

Clause 13. The silica-titania glass substrate of any one of clauses 1-12, wherein the refractive index variation is in a range from 20 ppm to 60 ppm.

Clause 14. The silica-titania glass substrate of any one of clauses 1-13, wherein the concentration of OH groups is in a range from 600 ppm to 1400 ppm.

Clause 15. The silica-titania glass substrate of any one of clauses 1-14, wherein the concentration of OH groups is in a range from 700 ppm to 1200 ppm.

Clause 16. A method comprising:
subjecting a substrate (i) formed from soot particles, each of the soot particles comprising $SiO_2$ and $TiO_2$, and (ii) comprising greater than or equal to 0.05 gas inclusions per 16.4 $cm^3$ (cubic inch), to an environment having an elevated temperature and an elevated pressure for a period of time until the substrate comprises 0.05 gas inclusions, or less, per 16.4 $cm^3$ (cubic inch).

Clause 17. The method of clause 16 further comprising:
before subjecting the substrate to the environment, (i) forming the soot particles as loose soot particles, and (ii) collecting the soot particles.

Clause 18. The method of any one of clauses 16-17, further comprising:

before subjecting the substrate to the environment, (i) molding the soot particles at room temperature into a molded precursor substrate having a predetermined density in a range from 0.50 g/cm3 to 1.20 g/cm3, and (ii) heat treating the molded precursor substrate in the presence of steam, forming the substrate;
wherein, the substrate is opaque following the step of heat treating the molded precursor substrate.

Clause 19. The method of any one of clauses 16-17, further comprising:

before subjecting the substrate to the environment, (i) molding the soot particles at room temperature into a molded precursor substrate having a predetermined density in a range from 0.50 g/cm3 to 1.20 g/cm3, (ii) heat treating the molded precursor substrate in the presence of steam, thus forming a consolidated molded precursor substrate, and (iii) melting the consolidated precursor substrate into a melt that flows into a mold, thus, upon subsequent cooling, forms the substrate;
wherein, the elevated temperature of the environment of the subjecting step is in a range from 1000 °C to 1150 °C.

Clause 20. The method of any one of clauses 18-19, wherein
heat treating the molded precursor substrate in the presence of steam comprises subjecting the molded precursor substrate to a consolidation environment into which steam is introduced to achieve a pressure within the consolidation environment in a range from 0.1 atm to 10 atm.

Clause 21. The method of any one of clauses 16-20, further comprising:
after subjecting the substrate to the environment, annealing the substrate for at least 100 hours with a maximum temperature in a range from 900 °C to 1200 °C.

Clause 22. The method of any one of clauses 16-21, further comprising:
after subjecting the substrate to the environment, slicing the substrate into a plurality of substrates, each of the plurality of substrates having a mass in a range from 100 grams to 1 kg.

Clause 23. The method of clause 22, wherein
each of the plurality of substrates comprise 0.01 gas inclusions, or less, per 16.4 $cm^3$ (cubic inch).

Clause 24. The method of clause 22, wherein
each of the plurality of substrates comprise no gas inclusions.

Clause 25. The method of any one of clauses 22-24, further comprising:
applying a reflective multilayer film on at least one of the plurality of substrates; and forming an absorber on the reflective multilayer film.

Clause 26. The method of any one of clauses 16-25, wherein before subjecting the substrate to the environment, the gas inclusions comprise one or more of CO and CO2.

Clause 27. The method of clause 26, wherein
before subjecting the substrate to the environment, the gas inclusions comprise at least 70 mole percent combined of CO and CO2.

Clause 28. The method of any one of clauses 16-27, wherein
the environment having the elevated temperature and the elevated pressure comprises an inert gas.

Clause 29. The method of any one of clauses 16-28, wherein
the elevated temperature is in a range from 1000 °C to 1800 °C.

Clause 30. The method of any one of clauses 16-29, wherein the elevated pressure is in a range from 3447.4 kPa to 103421.4 kPa (0.5 kpsi to 15 kpsi).

Clause 31. The method of any one of clauses 16-30, wherein
the period of time is at least 1 hour.

Clause 32. The method of any one of clauses 16-31, wherein
before the period of time begins and while the substrate is in the environment, a temperature of the environment is increased from room temperature to the elevated temperature at a temperature increase rate in a range from 125 °C/hr to 500 °C/hr.

Clause 33. The method of any one of clauses 16-32, wherein
after the period of time ends and while the substrate is in the environment, the temperature of the environment is decreased from the elevated temperature to room temperature at a temperature decrease rate in a range from 125 °C/hr to 500 °C/hr.

Clause 34. The method of any one of clauses 16-33, wherein

the elevated pressure is in a range from 8963.2 kPa to 11721.1 kPa (1.3 kpsi to 1.7 kpsi);
the elevated temperature is in a range from 1650 °C to 1800 °C; and
the period of time is in a range from 8 hours to 12 hours;
before the period of time begins and while the substrate is in the environment, a temperature of the environment is increased from room temperature to the elevated temperature at a temperature increase rate in a range from 250 °C/hr to 350 °C/hr; and
after the period of time ends and while the substrate is in the environment, the temperature of the environment is decreased from the elevated temperature to room temperature at a temperature decrease rate in a range from 250 °C/hr to 350 °C/hr.

Clause 35. The method of any one of clauses 16-34, wherein
during the subjecting the substrate to the environment, a support comprising graphite supports the substrate.

Clause 36. The method of any one of clauses 16-35, wherein
after subjecting the substrate to the environment, the substrate comprises:

(i) a composition comprising 5 weight percent to 10 weight percent $TiO_2$;
(ii) a coefficient of thermal expansion (CTE) at 20 °C in a range from -45 ppb/K to +20 ppb/K;
(iii) a crossover temperature (Tzc) in a range from 10 °C to 50 °C;
(iv) a slope of CTE at 20 °C in a range from 1.20 ppb/K2 to 1.75 ppb/K2;
(v) a refractive index variation of 140 ppm, or less,; and
(vi) a concentration of OH groups of 600 ppm or greater.

Clause 37. The method of any one of clauses 16-36, wherein
after subjecting the substrate to the environment, the substrate comprises: a hardness in a range from 4.60 GPa to 4.75 GPa.

Clause 38. The method of any one of clauses 16-37, wherein

the crossover temperature (Tzc) is in a range from 20 °C to 38 °C;
the slope of CTE at 20 °C is in a range from 1.30 ppb/K2 to 1.65 ppb/K2;
the refractive index variation is in a range from 20 ppm to 60 ppm; and
the concentration of OH groups is in a range from 600 ppm to 1400 ppm.

Clause 39. The method of any one of clauses 16-21 and 26-38, wherein

the substrate further comprises a mass of 1 kg or greater; and
after subjecting the substrate to the environment, the substrate further comprises 0.05 gas inclusions, or less, per 16.4 cm$^3$ (cubic inch).

Clause 40. The method of clause 39, wherein
after subjecting the substrate to the environment, the substrate further comprises no gas inclusions.

Clause 41. The method of any one of clauses 16-21 and 26-40 further comprising: applying a reflective multilayer film on the substrate; and
forming an absorber on the reflective multilayer film.

Clause 42. A method comprising:

forming soot particles comprising SiO2 and TiO2 as loose soot particles;
collecting the soot particles;
molding the soot particles into a molded precursor substrate;
heat treating the molded precursor substrate in the presence of steam, forming a substrate, the substrate comprising greater than or equal to 0.05 gas inclusion per 16.4 cm$^3$ (cubic inch); and
subjecting the substrate to an environment having an elevated temperature in a range from 1000 °C to 1800 °C and an elevated pressure in a range from 3447.4 kPa to 103421.4 kPa (0.5 kpsi to 15 kpsi) for a period of time in a range from 1 hour to 120 hours until the number of the gas inclusions per 16.4 cm$^3$ (cubic inch) has reduced to 0.05 gas inclusions, or less, per 16.4 cm$^3$ (cubic inch).

Clause 43. The method of clause 42, wherein

before the predetermined period of time begins, a temperature of the environment is increased from room temperature to the elevated temperature in the presence of the substrate at a temperature increase rate in a range from 125 °C/hr to 500 °C/hr; and
after the predetermined period of time ends, the temperature of the environment is decreased from the elevated temperature to room temperature in the presence of the substrate at a temperature decrease rate in a range from 125 °C/hr to 500 °C/hr.

Clause 44. The method of any one of clauses 42-43, wherein, after the substrate is subjected to the environment, the substrate comprises:

a composition comprising 5 weight percent to 10 weight percent TiO$_2$;
a coefficient of thermal expansion (CTE) at 20 °C in a range from -45 ppb/K to +20 ppb/K;
a crossover temperature (Tzc) in a range from 10 °C to 50 °C;
a slope of CTE at 20 °C in a range from 1.20 ppb/K2 to 1.75 ppb/K2;
a refractive index variation of 140 ppm or less;
a concentration of OH groups of 600 ppm or greater; and

a hardness in a range from 4.60 GPa to 4.75 GPa.

**BRIEF DESCRIPTION OF THE DRAWINGS**

FIG. 1 is a flowchart of a method of forming a substrate having few or no gas inclusions and a composition with ultralow thermal expansion properties, making the substrate suitable for EUV applications;

FIG. 2 is a schematic of a system to form soot particles having a composition comprising $SiO_2$ and $TiO_2$;

FIG. 3 is a schematic flowchart of the method of forming the substrate;

FIGS. 4A and 4B are photographs of a representative substrate before and after subjecting the substrate to an environment having an elevated temperature and an elevated pressure for a period of time, illustrating at FIG. 4A the substrate having many gas inclusions, and at FIG. 4B, after being subjected to the environment having the elevated temperature and the elevated pressure for the period of time, having no gas inclusions;

FIG. 4C is a graph showing the temperature and the pressure as a function of the period of time of the environment to which the substrate of FIGS. 4A and 4B were subjected;

FIGS. 5A-5D pertains to Examples 5A-5D and each illustrates a map of refractive index homogeneity for each sample.

**DETAILED DISCLOSURE**

As used herein, "ppm" means parts per million by weight.

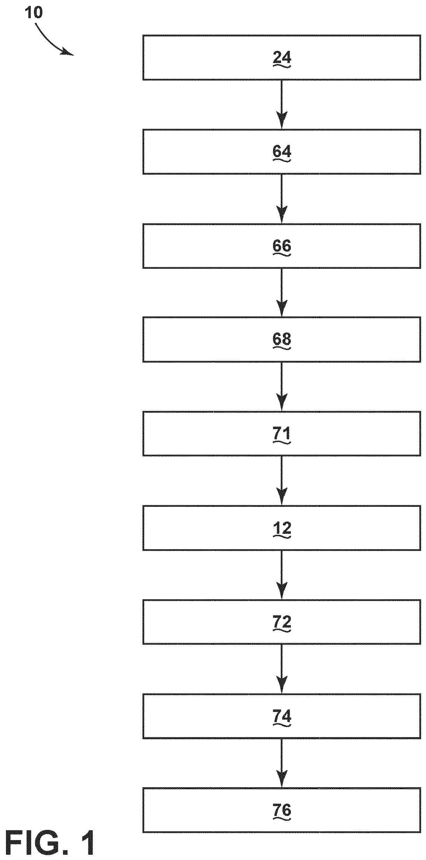

Referring now to FIGS. 1-3, a method 10, at a step 12, comprises subjecting a substrate 14 (i) formed from soot particles 16, each of the soot particles 16 comprising $SiO_2$ and $TiO_2$, and (ii) comprising greater than or equal to 0.05 gas inclusions 18 per 16.4 $cm^3$ (cubic inch), to an environment 20 having an elevated temperature and an elevated pressure for a period of time until the substrate 14 comprises 0.05 gas inclusions 18, or less, per 16.4 $cm^3$ (cubic inch). In embodiments, before subjecting the substrate 14 to the environment 20, the substrate 14 has greater than or equal to 0.10 gas inclusions 18 per 16.4 $cm^3$ (cubic inch), greater than or equal to 0.20 gas inclusions 18 per 16.4 $cm^3$ (cubic inch), greater than or equal to 0.30 gas inclusions 18 per 16.4 $cm^3$ (cubic inch), greater than or equal to 0.40 gas inclusions 18 per 16.4 $cm^3$ (cubic inch), greater than or equal to 0.50 gas inclusions 18 per 16.4 $cm^3$ (cubic inch), greater than or equal to 0.60 gas inclusions 18 per 16.4 $cm^3$ (cubic inch), greater than or equal to 0.70 gas inclusions 18 per 16.4 $cm^3$ (cubic inch), greater than or equal to 0.80 gas inclusions 18 per 16.4 $cm^3$ (cubic inch), greater than or equal to 0.90 gas inclusions 18 per 16.4 $cm^3$ (cubic inch), or greater than or equal to 1.0 gas inclusions 18 per 16.4 $cm^3$ (cubic inch). In embodiments, before subjecting the substrate 14 to the environment 20, the substrate 14 has 0.05 gas inclusions 18 per 16.4 $cm^3$ (cubic inch), 0.10 gas inclusions 18 per 16.4 $cm^3$ (cubic inch), 0.20 gas inclusions 18 per 16.4 $cm^3$ (cubic inch) 0.30 gas inclusions 18 per 16.4 $cm^3$ (cubic inch),0.40 gas inclusions 18 per 16.4 $cm^3$ (cubic inch),0.50 gas inclusions 18 per 16.4 $cm^3$ (cubic inch), 0.60 gas inclusions 18 per 16.4 $cm^3$ (cubic inch), 0.70 gas inclusions 18 per 16.4 $cm^3$ (cubic inch), 0.80 gas inclusions 18 per 16.4 $cm^3$ (cubic inch), 0.90 gas inclusions 18 per 16.4 $cm^3$ (cubic inch), 1.0 gas inclusions 18 per 16.4 $cm^3$ (cubic inch), 2.0 gas inclusions 18 per 16.4 $cm^3$ (cubic inch), 4.0 gas inclusions 18 per 16.4 $cm^3$ (cubic inch), or a number of gas inclusions 18 within a range bound by any two of those values (e.g., 0.10 to 1.0 gas inclusions 18 per 16.4 $cm^3$ (cubic inch), 0.30 to 4.0 gas inclusion 18 per 16.4 $cm^3$ (cubic inch), etc.). A pressure-tolerant chamber 21 can provide the environment 20.

For purposes of this disclosure, a "gas inclusion" means a gaseous bubble that is (i) disposed within the substrate 14 and (ii) has a dimension of at least 50 $\mu$m. The number of gas inclusions 18 per 16.4 $cm^3$ (cubic inch) can be determined by visual inspection of the entire substrate under back and side lighting. Gas inclusions 18 become visually detectable when the gas inclusion has a dimension of about 50 $\mu$m. For an approximately spherical gas inclusion 18, the dimension is the diameter of the gas inclusion 18. For an elongated gas inclusion 18, the dimension is the major axis of the gas inclusion 18. White light optical microscopy can be utilized to determine the value of the dimension of any particular gas inclusion 18. However, if the gas inclusion 18 is visible without the aid of optical microscopy, then it can be assumed that the gas inclusion 18 has a dimension of at least 50 $\mu$m.

After subjecting the substrate 14 to the environment 20 at the step 12 of the method 10, the substrate 14 has less than 0.05 gas inclusions 18 per 16.4 $cm^3$ (cubic inch). In embodiments, after subjecting the substrate 14 to the environment 20 at the step 12 of the method 10, the substrate 14 has less than 0.04 gas inclusions 18 per 16.4 $cm^3$ (cubic inch), less than 0.03 gas inclusions per 16.4 $cm^3$ (cubic inch), or less than 0.02 gas inclusions 18 per 16.4 $cm^3$ (cubic inch). In embodiments, after subjecting the substrate 14 to the environment 20 at the step 12 of the method 10, the substrate 14 has less than 0.01 gas inclusions 18 per 16.4 $cm^3$ (cubic inch). In embodiments, after subjecting the substrate 14 to the environment 20 at the step 12 of the method 10, the substrate 14 has no gas inclusions 18.

In embodiments, the substrate 14 has a mass of 1 kg or greater. In embodiments, the substrate 14 has a mass of 1kg to 5 kg, 1 kg to 50 kg, or 5 kg to 50 kg. In embodiments, the substrate 14 has a mass of 1 kg, 2 kg, 3 kg, 5 kg, 10 kg, 15 kg, 20 kg, 25 kg, 30 kg, 35 kg, 40 kg, 45 kg, 50 kg, or any range between any two of those values (e.g., 10 kg to 25 kg, 15 kg to 45 kg, etc.). The mass of the substrate 14 can be determined with a scale. In embodiments, the substrate 14 has a mass of 1 kg or greater, and after subjecting the substrate 14 to the environment 20 at the step 12 of the method 10, the substrate 14 has less than 0.05 gas inclusions 18 per 16.4 $cm^3$ (cubic inch), such as no gas inclusions 18, or 0.01 gas inclusions 18 per 16.4 $cm^3$ (cubic inch) to 0.05 gas inclusions 18 per 16.4 $cm^3$ (cubic inch). In embodiments, the substrate 14 has a mass in a range from 1 kg to 5 kg, and after subjecting the substrate 14 to the environment 20 at the step 12 of the method 10, the substrate 14 has less than 0.05 gas inclusions 18 per 16.4 $cm^3$

(cubic inch), such as no gas inclusions 18, or 0.01 gas inclusions 18 per 16.4 cm$^3$ (cubic inch) to 0.05 gas inclusions 18 per 16.4 cm$^3$ (cubic inch).

In embodiments, the gas inclusions 18 comprise one or more of CO and $CO_2$. In embodiments, the gas inclusions 18 comprise at least 70 mole percent combined of CO and $CO_2$. In embodiments, the gas inclusions 18 comprise $N_2$, either alone or in addition to the one or more of CO and $CO_2$. It is believed that the presence of CO and/or $CO_2$ is at least in part a consequence of fuel combusted during formation of the soot particles 16, which is discussed further below. The gas within the gas inclusions 18 is at a pressure near atmospheric pressure.

In embodiments, the environment 20 having the elevated temperature and the elevated pressure comprises an inert gas. By "inert gas," it is meant a gas that does not chemically react with the substrate 14. In embodiments, the inert gas is one or more of the noble gases. In embodiments, the inert gas is one or more of helium, neon, argon, krypton, and xenon. In embodiments, the inert gas is helium, neon, argon, krypton, or xenon. In embodiments, the inert gas is argon.

In embodiments, the elevated pressure is in a range from 3447.4 kPa to 103421.4 kPa (0.5 kpsi to 15 kpsi). In embodiments, the elevated pressure is in a range from 9652.7 kPa to 103421.4 kPa (1.4 kpsi to 15 kpsi). In embodiments, the elevated pressure is 3447.4 kPa (0.5 kpsi), 4136.9 kPa (0.6 kpsi), 4826.3 kPa (0.7 kpsi), 5515.8 kPa (0.8 kpsi), 6205.3 kPa (0.9 kpsi), 6894.8 kPa (1.0 kpsi), 7584.2 kPa (1.1 kpsi), 8273.7 kPa (1.2 kpsi), 8963.2 kPa (1.3 kpsi), 9652.7 kPa (1.4 kpsi), 10342.1 kPa (1.5 kpsi), 13789.5 kPa (2 kpsi), 20684.3 kPa (3 kpsi), 27579.0 kPa (4 kpsi), 34473.8 kPa (5 kpsi), 41368.5 kPa (6 kpsi), 48263.3 kPa (7 kpsi), 55158.1 kPa (8 kpsi), 62052.8 kPa (9 kpsi), 68947.6 kPa (10 kpsi), 75842.3 kPa (11 kpsi), 82737.1 kPa (12 kpsi), 89631.8 kPa (13 kpsi), 96526.6 kPa (14 kpsi), 103421.4 kPa (15 kpsi), or within a range bounded by any two of those values (e.g., 5515.8 kPa to 103421.4 kPa (0.8 kpsi to 15 kpsi), 13789.5 kPa to 68947.6 kPa (2 kpsi to 10 kpsi), 41368.5 kPa to 82737.1 kPa (6 kpsi to 12 kpsi), etc.). All pressures disclosed herein are gauge pressures.

In embodiments, the elevated temperature is in a range from 1000 °C to 1800 °C. In embodiments, the elevated temperature is 1000 °C, 1100 °C, 1200 °C, 1300 °C, 1400 °C, 1500 °C, 1600 °C, 1601 °C, 1650 °C, 1700 °C, 1750 °C, 1775 °C, 1800 °C, or within a range bounded by any two of those values (e.g., 1100 °C to 1700 °C, 1300 °C to 1400 °C, 1601 °C to 1800 °C, etc.).

In embodiments, the substrate 14 is subjected to the environment 20 for a period of time of at least 1 hour. In embodiments, the substrate 14 is subjected to the environment 20 for a period of time in a range from 1 hour to 120 hours. In embodiments, the period of time is 1 hour, 2 hours, 3 hours, 4 hours, 5 hours, 6 hours, 7 hours, 8 hours, 9 hours, 10 hours, 11 hours, 12 hours, 13 hours, 14 hours, 15 hours, 16 hours, 17 hours, 18 hours, 19 hours, 20 hours, 21 hours, 22 hours, 23 hours, 24 hours, 36 hours, 48 hours, 60 hours, 72 hours, 84 hours, 96 hours, 108 hours, 120 hours, or within a range by any two of those values (e.g., 1 hours to 24 hours, 10 hours to 108 hours, 11 hours to 36 hours, 24 hours to 120 hours, etc.). In embodiments, a support 22 comprising graphite supports the substrate 14 during the step 12 of subjecting the substrate 14 to the environment 20.

In embodiments, the elevated pressure is in a range from 8963.2 kPa to 11721.1 kPa (1.3 kpsi to 1.7 kpsi); (ii) the elevated temperature is in a range from 1650 °C to 1800 °C; (iii) the period of time is in a range from 8 hours to 12 hours; (iv) before the period of time begins and while the substrate is in the environment, a temperature of the environment is increased from room temperature to the elevated temperature at a temperature increase rate in a range from 250 °C/hr to 350 °C/hr; and (v) after the period of time ends and while the substrate is in the environment, the temperature of the environment is decreased from the elevated temperature to room temperature at a temperature decrease rate in a range from 250 °C/hr to 350 °C/hr. In embodiments, (i) the elevated pressure is in a range from 89631.8 kPa to 117210.9 kPa (13 kpsi to 17 kpsi), (ii) the elevated temperature is in a range from 1650 °C to 1800 °C, and (iii) the period of time is in a range from 8 hours to 12 hours. In embodiments, (i) the elevated pressure is 1000 atm (~14.7 kpsi), (ii) the elevated temperature is 1750 °C, and (iii) the period of time is 10 hours. Higher temperatures can accommodate lower pressures. Higher pressures can accommodate lower temperatures. Lower temperatures combined with lower pressures have been found to inadequately remove gas inclusions 18 from the substrate 14 - i.e., elevated temperatures of 900 °C to 1000 °C combined with an elevated pressure of 103421.4 kPa (15 kpsi) produced inadequate reduction of the number of gas inclusions 18 throughout the substrate 14. Likewise, an elevated temperature of 1100 °C combined with an elevated pressure of 10342.1 kPa (1.5 kpsi) produced inadequate reduction of the number of gas inclusions 18 throughout the substrate 14.

In embodiments, before the period of time begins and while the substrate 14 is in the environment 20, a temperature of the environment 20 is increased from room temperature to the elevated temperature at a temperature increase rate in a range from 150 °C/hr to 500 °C/hr. In embodiments, the temperature increase rate is 150 °C/hr, 200 °C/hr, 250 °C/hr, 300 °C/hr, 350 °C/hr, 400 °C/hr, 450 °C/hr, 500 °C/hr, or within any range bounded by any two of those values (e.g., 250 °C/hr to 350 °C/hr, 200 °C/hr to 300 °C/hr, etc.). In embodiments, after the predetermined period of time ends and while the substrate 14 is in the environment 20, the temperature of the environment 20 is decreased from the elevated temperature to room temperature at a temperature decrease rate in a range from 150 °C to 500 °C/hr. In embodiments, the temperature decrease rate is 150 °C/hr, 200 °C/hr, 250 °C/hr, 300 °C/hr, 350 °C/hr, 400 °C/hr, 450 °C/hr, 500 °C/hr, or within any range bounded by any two of those values (e.g., 250 °C/hr to 350 °C/hr, 200 °C/hr to 300 °C/hr, etc.). In embodiments, the temperature increase rate is the same as the temperature decrease rate. In other embodiments, the temperature increase rate is different than the temperature decrease rate. In embodiments, the elevated pressure of 103421.4 kPa (15 kpsi), the elevated temperature of 1750 °C, for a period of time of 10 hours, with the temperature increase rate and the temperature decrease rate of 300 °C/hr results in the removal of nearly all gas inclusions 18 having a dimension in a range from about 1 mm to 2 mm or less when the substrate 14 has a mass of about 6 kg.

The step 12 of subjecting the substrate 14 to the environment 20 having the elevated pressure and the elevated temperature is sometimes referred to as "hot isostatic pressing." Without being bound by theory, it is believed that the elevated temperature and elevated pressure cause the gas within the gas inclusion 18 to diffuse or dissolve into the silica-titania glass. The diffusion or dissolution of the gas causes the dimensions of the gas inclusion 18 to decrease either below the dimensions required to be visible without optical magnification (i.e., having a dimension of less than about 50 $\mu$m) or to collapse entirely. More specifically, it is thought that the pressure that the environment 20 imparts upon the gas inclusion 18 causes the dimension of the gas inclusion 18 to decrease and thereby increase in pressure to equalize with the pressure of the environment 20. In addition, the increase in pressure within the gas inclusion 18 increases the equilibrium solubility of the gas within the gas inclusion 18 (e.g., CO, $CO_2$, $N_2$), which causes molecules of the gas to exit the gas inclusion 18 and enter the silica-titania glass structure. The departing molecules reduce the pressure with the gas inclusion 18, further causing the dimension of the gas inclusion 18 to decrease. This diffusion or dissolution process can continue until the gas inclusion 18 collapses entirely.

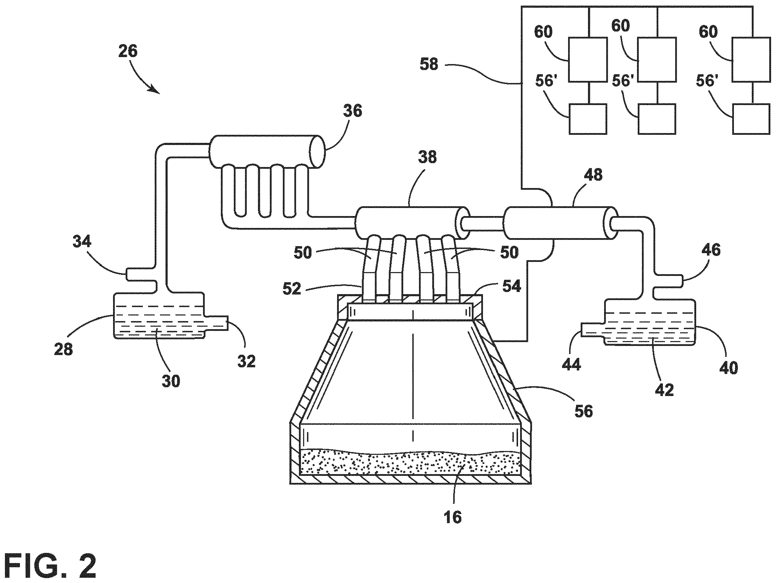

In embodiments, the method 10 further includes, at a step 24, before subjecting the substrate 14 to the environment 20 at the step 12, (i) forming the soot particles 16 as loose soot particles 16, and (ii) collecting the soot particles 16. Referring particularly to FIG. 2, to form the soot particles 16 as loose soot particles 16, a system 26 can be utilized. The system 26 includes a source 28 of a silica precursor 30. The source 28 has an inlet 32 for a carrier gas, such as nitrogen, at or near the base of the source 28 to form a vaporous stream with the silica precursor 30. A bypass stream of carrier gas is introduced at another inlet 34 to prevent saturation of the vaporous stream. The vaporous stream passes through a distribution system 36 to a manifold 38.

The system 26 additionally includes a source 40 of a titania precursor 42. The source 40 also has an inlet 44 for a carrier gas that is transmitted through the titania precursor 42, forming a vaporous stream with the titania precursor 42. A by-pass stream of carrier gas is introduced at another inlet 46. The vaporous stream passes through another distribution system 48 to the manifold 38.

The vaporous stream with the silica precursor 30 and the vaporous stream with the titania precursor 42 mix in the manifold 38 to form a mixture of the two vaporous streams. The mixture passes through fume lines 50 to burners 52 mounted in upper portion of a furnace 54. The mixture of the two vaporous streams is further joined with a fuel/oxygen mixture at the burners 52. The fuel can be natural gas. The mixture combusts and is oxidized at a temperature in excess of 1600 °C to form the loose soot particles 16, each soot particle 16 comprising $SiO_2$ and $TiO_2$. In other words, silicon dioxide and titanium dioxide mix at the atomic level to form Si-O-Ti bonds in each soot particle 16. Each of the soot particles 16 may additionally contain regions of silicon dioxide and regions of titanium dioxide. The loose soot particles 16 cool and are directed into a collection chamber 56, where the collection of the soot particles 16 occurs. Representative silica precursors 30 include $SiCl_4$ and octamethylcyclotetrasiloxane (OMCTS). Representative titania precursors 42 include $TiCl_4$, titanium tetraisopropoxide (TTIP), and tetraisopropyltitanate (TPT). The relative flow rates of the vaporous stream with the silica precursor 30 and the vaporous stream with titania precursor 42 are selected to form soot particles 16 for producing the substrate 14 with the desired weight percentage of $TiO_2$. In embodiments, the relative flow rates of the vaporous stream with the silica precursor 30 and the vaporous stream with titania precursor 42 are set so the resulting substrate 14 comprises 5 weight percent to 10 weight percent $TiO_2$. The weight percentage of the $TiO_2$ in the soot particles 16 and the resulting substrate 14 can be determined via X-ray fluorescence ("XRF").

In other embodiments, instead of the soot particles 16 falling vertically downward as described, the soot particles 16 are directed upward through a quartz tube 58 where the flow carries the soot particles 16 to one or more filter bags 60 designed to remove the soot particles 16. A pulse of $N_2$ is periodically applied to the filter bags 60 to prevent excess accumulation of soot particles 16 onto the filter bags 60. The soot particles 16 fall from each of the one or more filter bags 60 into one or more collection chambers 56', each of which can be a stainless steel hopper disposed below a separate one of the filter bags 60. The soot particles 16 can then be further collected from the stainless steel hoppers into 55 gallon barrels, where the soot particles 16 are stored until being molded into a molded precursor substrate 62, which is further discussed below.

In embodiments, the soot particles 16 cool to about 200 °C or less before reaching the collection chambers 56, 56'. In embodiments, the soot particles 16 cool to room temperature before being removed from the collection chambers 56, 56'. In embodiments, the soot particles 16 are spherical. In embodiments, the soot particles have a specific surface area determined according to the Brunauer, Emmett and Teller ("BET") theory of less than 80 $m^2/g$, less than 70 $m^2/g$, less than 60 $m^2/g$, or less than 50 $m^2/g$. In embodiments, the soot particles have a specific surface area determined according to the Brunauer, Emmett and Teller ("BET") theory of 10 $m^2/g$, 20 $m^2/g$, 30 $m^2/g$, 40 $m^2/g$, 50 $m^2/g$, 60 $m^2/g$,

70 m$^2$/g, 80 m$^2$/g, or within any range bounded by any two of those values (e.g., 10 m$^2$/g to 60 m$^2$/g, 20 m$^2$/g to 70 m$^2$/g, etc.).

Because the fuel at the burners 52 is typically carbon-based, the soot particles 16 have a composition that may further comprises CO and CO$_2$, in addition to the SiO$_2$ and TiO$_2$. This CO and CO$_2$ is one contribution to the gas inclusions 18 present in the substrate 14 before the step 12 of subjecting the substrate 14 to the environment 20 having the elevated temperature and the elevated pressure. This is in contrast to a substrate formed via the "direct-to-glass" process described in the background, which typically does not result in gas inclusions 18 and, if present, the gas inclusions 18 produced in the "direct-to-glass" process generally comprise O$_2$ and lack CO and CO$_2$.

In embodiments, the method 10 further includes, before subjecting the substrate 14 to the environment 20, (i) at a step 64, molding the soot particles 16 at room temperature into a molded precursor substrate 66 having a predetermined density in a range from 0.50 g/cm$^3$ to 1.20 g/cm$^3$, and (ii) at a step 68, heat treating the molded precursor substrate 66 in the presence of steam, forming a consolidated molded precursor substrate 70. To mold the soot particles 16 into the molded precursor substrate, soot particles 16 are obtained from the collection chambers 56, 56' and then transferred to a mold. The mold is shaped to impart the soot particles 16 with a shape desired for the molded precursor substrate 66. The molded precursor substrate 66 is sometimes referred to as a "soot blank." In embodiments, the mold is cylindrical (e.g., 10 inch inner diameter) and comprises graphite, and the soot particles 16 are uniaxially pressed until the molded precursor substrate 66 has a density in a range from 0.50 g/cm$^3$ to 1.20 g/cm$^3$. In embodiments, the soot particles 16 are uniaxially pressed until the molded precursor substrate 66 has a density of of 0.50 g/cm$^3$, 0.60 g/cm$^3$, 0.70 g/cm$^3$, 0.80 g/cm$^3$, 0.90 g/cm$^3$, 1.00 g/cm$^3$, 1.10 g/cm$^3$, 1.20 g/cm$^3$, or within any range bounded by any two of those values (e.g., 0.70 g/cm$^3$ to 1.10 g/cm$^3$, 0.80 g/cm$^3$ to 1.00 g/cm$^3$, etc.). The pressing mechanism may include an ultrasonic gauge used to determine the density. Once the soot compact is pressed to the predetermined density, as measured by the ultrasonic gauge, movement of the pressing plate may be stopped. In embodiments, a constant pressing rate is utilized and is followed by an extended hold. The nitrogen prevents combustion of the graphite mold. The mold defines the shape of the molded precursor substrate 66, which in embodiments, is cylindrical.

The step 68 of the method 10 of heat treating the molded precursor substrate 66 in the presence of steam, forming the consolidated molded precursor substrate 70, may be referred to as "consolidation." For the step 68, the molded precursor substrate 66 is placed into a furnace providing a consolidation environment with air or an inert gas at an elevated temperature to purge and remove at least a portion of gases presented in the molded precursor substrate 66. The elevated temperature within the consolidation environment can be in a range from 100° C to 900° C, in a range from 200° C to 700° C, or in a range from 300° C to 600° C.

The consolidation environment within the furnace is then changed to steam by flowing steam at a constant rate to achieve a pressure within the furnace of up to 10 atmosphere, such as a pressure in a range from 0.1 atm to 10 atm, or a pressure in a range from 0.5 atm to 5.0 atm, or a pressure in a range from 0.7 atm to 2.5 atm, or a pressure in a range from 0.9 to 1.3 atm. The temperature of the consolidation environment is in a range from 900° C to 1850° C, in a range from 900° C to 1700° C, in a range from 900° C to 1500° C, or in a range from 900° C to 1300° C. The time of exposure of the molded precursor substrate 66 in the consolidation environment may be at least 0.5 hour, at least 1 hour, at least 2 hours, or at least 5 hours. This causes the molded precursor substrate 66 to densify into the consolidated molded precursor substrate 70. In embodiments, consolidated molded precursor substrate 70 is opaque following the step 68 of heat treating the molded precursor substrate 66 in the presence of steam.

In embodiments, after the step 68 of heat treating the molded precursor substrate 66 in the presence of steam (i.e., consolidation) to form the consolidated molded precursor substrate 70, the consolidated molded precursor substrate 70 is the substrate 14 that is subject to the environment 20 at step 12 with the elevated pressure and the elevated temperature.

In other embodiments, after the step 68 of heat treating the molded precursor substrate 66 in the presence of steam (i.e., consolidation) and before subjecting the substrate 14 to the environment 20, the method 10 at a step 71 further comprises melting the consolidated molded precursor substrate 66 into a melt that flows into a mold, thus, upon subsequent cooling, forms the substrate 14. In embodiments, the mold comprises graphite. This melting process can be performed within a graphite furnace with a N$_2$ atmosphere. The temperature within the furnace around the consolidated molded precursor substrate 70 is gradually raised to at least the melting temperature of the consolidated molded precursor substrate 70. The consolidated molded precursor substrate 70 melts and takes the form that the mold defines. Upon cooling, the substrate 14 is formed. The substrate 14 loses the opaqueness produced during the step 68 of consolidation in the presence of steam. However, the gas inclusions 18 again form throughout the substrate 14. The outer surface of the substrate 14 may have discoloration that contacting the graphite of the mold causes. The discoloration can be removed via machining or cutting.

As mentioned above, in embodiments, the elevated temperature during the step 12 of subjecting the substrate 14 to the environment 20 is in a range from 1000 °C to 1800 °C. In embodiments, the lower end of the range for the elevated temperature (e.g., in a range from 1000 °C to 1200 °C, or in a range from 1000 °C to 1150 °C) is utilized when the step 71 was utilized to melt the consolidated molded precursor substrate 70, and thereafter cooling to form the substrate 14. When the step 71 is not utilized, and the consolidated molded precursor substrate 70 is the substrate 14 at the step 12 subjected to the environment 20 having the elevated temperature and the elevated temperature, the lower end of the range for the elevated temperature typically will not result in the collapse of the gas inclusions 18 and the higher end of the range for the elevated temperature (e.g., in a range from 1700 °C to 1800 °C) should be utilized to collapse the gas inclusions 18.

In embodiments, after the subjecting the substrate 14 to the environment 20, the method 10 further comprises a step 72 of annealing the substrate 14. The step of annealing the substrate 14 relaxes internal stresses in the substrate 14. The relaxed internal stresses allow for better quality cutting and machining, such as slicing the substrate 14 into a plurality of substrates 14a, 14b, ... 14n suitable for use with EUV applications (as discussed further below). In addition, the step 72 of annealing the substrate 14 lowers the crossover temperature of the substrate 14 and flattens the slope of CTE of the substrate 14. The longer the anneal, the flatter the slope of CTE of the substrate 14. In embodiments, the step 72 of annealing the substrate 14 comprises annealing for a period of time of at least 100 hours with a maximum temperature of in a range from 900 °C to 1200 °C. In embodiments, the step 72 of annealing the substrate 14 comprises annealing for a period of time of at least 250 hours with a maximum temperature of in a range from 900 °C to 1000 °C.

The substrate 14 is thus a silica-titania substrate. The substrate 14 comprises a composition comprising 5 weight percent to 10 weight percent $TiO_2$, and 90 weight percent to 95 weight percent $SiO_2$. In embodiments, the composition of the substrate 14 further comprises 0.001 to 0.01 weight percent carbon. The presence of carbon in the substrate 14 is a consequence of the diffusion of molecules of the CO and $CO_2$ from the gas inclusions 18 into the substrate 14. The composition of the substrate 14 is determined using quantitative analysis techniques well known in the art. Suitable techniques are X-ray fluorescence spectrometry (XRF) for elements with an atomic number higher than 8, inductively coupled plasma optical emission spectrometry (ICP-OES), inductively coupled plasma mass spectrometry (ICP-MS), and electron microprobe analysis. See, for example, J. Nolte, ICP Emission Spectrometry: A Practical Guide, Wiley-VCH (2003), H. E. Taylor, Inductively Coupled Plasma Mass Spectroscopy: Practices and Techniques, Academic Press (2000), and S. J. B. Reed, Electron Microprobe Analysis, Cambridge University Press; 2nd edition (1997). For an analysis time of about 10 minutes for each element, detection limits of approximately 200 ppm for F and approximately 20 ppm for Cl, Br, Fe, and Sn can be readily achieved using electron microprobe analysis. For trace elements, ICP-MS is preferred. In embodiments, the substrate 14 further comprises one or more solid inclusions that comprise iron. In embodiments, the substrate 14 further comprises one or more solid inclusions that comprise one or more of iron, chromium, zirconium, an oxide of iron, an oxide of chromium, an oxide of zirconium, and cristobalite.

After subjecting the substrate 14 to the environment 20, the substrate 14 has ultralow expansion properties that make the substrate 14 suitable for use with EUV lithography. In embodiments, the substrate 14, after the method 10, comprises a CTE at 20 °C in a range from -45 ppb/K to +20 ppb/K. In embodiments, the substrate 14, after the method 10, comprises a CTE at 20 °C of -45 ppb/K, -40 ppb/K, -35 ppb/K, -30 ppb/K, -25 ppb/K, -20 ppb/K, -15 ppb/K, -10 ppb/K, -5 ppb/K, 0 ppb/K, +5 ppb/K, +10 ppb/K, +15 ppb/K, +20 ppb/K, or within any range bounded by any two of those values (e.g., -40 ppb/K to -25 ppb/K, -15 ppb/K to +15 ppb/K, etc.).

The ultralow CTE at room temperature is critical in allowing the shape of the substrate 14, whether formed into a mirror or a photomask, to remain substantially constant upon heating during the EUV lithography process. The CTE of the substrate 14 is determined by the method 10 disclosed United States Patent No. 10,458,936, which is titled "Apparatus and method for the determination of the absolute coefficient of thermal expansion in ultralow expansion materials" and is hereby incorporated by reference in its entirety. A brief description of the technique follows below.

Thermal expansion of all the samples was measured using the Compact High Resolution Dilatometer (CHRD). The measurement consists of stepping the sample temperature in the range from approximately 25°C to 70°C; at each setpoint the sample temperature is stabilized before measuring sample length by means of optical interferometry. Care is taken to isolate the sample from the instrument in order to minimize systematic errors arising from instrument instabilities. All measurements are performed in high vacuum ($<5 \times 10^{-5}$ hPa) to avoid environmental effects on the interferometers and to achieve better temperature control.

The sample temperature is measured using a platinum resistance sensor in close thermal contact with the sample. The sensor was calibrated against a NIST-traceable standard, and the resistance measurements are carried out using a research-grade cryogenic temperature controller.

The error in the CTE is dominated by the measurement of $\Delta L$, which is in principle susceptible to systematic effects associated with instrument stability; minimization and correction of these effects has been the focus in development of the CHRD instrument. Data is corrected by the use of algorithms on data acquired with a certain amount of redundancy, as described in US Patent 10,458,936: measurements are not performed as a function of monotonically increasing temperature, but rather as the sample temperature is alternatively increased and decreased, which allows detection and correction of any drifts in the instrument.

Once the data is corrected, the temperature dependence of the change in length ($\Delta L$), with temperature is fitted using the expression shown in formula (1), where "*" means multiplication:

$$\Delta L = sLength*(CTE20*(T-20°C) + ½*Slope*(T-20°C)^2 - \tfrac{1}{3}*0.0105(ppb/°C^3)*(T-20°C)^3)$$

(1)

where

sLength = measured sample length, not fitted;
CTE20 = fitting parameter (sample CTE at 20°C, in ppb/ °C)
Slope = fitting parameter (CTE slope at 20°C, in ppb/ °C$^2$)
T = measured sample temperature, in °C.

Formula (1) for the change in length derives from a simplified quadratic expression for *CTE(T)* in ULE® Glass, valid in the range from ~0°C to ~80°C, given in formula (2):

$$CTE(T) = CTE20 + Slope*(T-20°C) - 0.0105 \text{ ppb/ °C}^3 *(T-20°C)^2 \qquad (2)$$

*CTE20* and *Slope* are sample-specific parameters and the results from this measurement. The coefficient for the quadratic term in the *CTE* formula is universal for ULE® glass, and SiO$_2$-TiO$_2$ glasses of similar composition, and is not fit in the processing of the data. It should be noted that the fits also include a length offset, which depends on the reference for the length measurements and is therefore irrelevant to the CTE measurement, which is only concerned with relative changes in length.

From a practical application point of view, an important glass parameter is the Temperature of Zero Crossover (Tzc) of the CTE(T) curve, which can be calculated using the fitted values of CTE20 and Slope using formula (3):

$$Tzc = 20 - \{-Slope + \text{SQRT}(Slope^2 + 4 \times 0.0105 \times CTE20)\}/(2 \times 0.0105) \qquad (3)$$

In embodiments, the substrate 14, after the method 10, comprises a crossover temperature (Tzc) in a range from 10 °C to 50 °C. In embodiments, the substrate 14, after the method 10, comprises a crossover temperature (Tzc) in a range from 20 °C to 38 °C, or in a range from 22 °C to 38 °C. In embodiments, the substrate 14, after the method 10, comprises a crossover temperature (Tzc) of 10 °C, 15 °C, 20 °C, 25 °C, 30 °C, 35 °C, 40 °C, 45 °C, 50 °C, or within any range bounded by any two of those values (e.g., 15 °C to 40 °C, 20 °C to 45 °C, etc.). The crossover temperature is the temperature at which the CTE of the substrate 14 is exactly zero. When the substrate 14 is utilized in EUV lithography applications, the crossover temperature is ideally within the temperatures that the substrate 14 is expected to experience, in order to minimize thermal expansion of the substrate 14 during the lithography process. Designers of EUV lithography systems calculate an optimum crossover temperature for each substrate 14 in the system, based on the thermal load, size, and heat removal rates afforded by the system. The crossover temperature of the substrate 14 is additionally determined by the technique disclosed in aforementioned United States Patent No. 10,458,936.

In embodiments, the substrate 14, after the method 10, has a slope of CTE at 20 °C in a range from 1.20 ppb/K$^2$ to 1.75 ppb/K$^2$. In embodiments, the substrate 14, after the method 10, has a slope of CTE at 20 °C of 1.20 ppb/K$^2$, 1.25 ppb/K$^2$, 1.30 ppb/K$^2$, 1.35 ppb/K$^2$, 1.40 ppb/K$^2$, 1.45 ppb/K$^2$, 1.50 ppb/K$^2$, 1.55 ppb/K$^2$, 1.60 ppb/K$^2$, 1.65 ppb/K$^2$, 1.70 ppb/K$^2$, 1.75 ppb/K$^2$, or within any range bounded by any two of those values (e.g., in a range from 1.30 ppb/K$^2$ to 1.65 ppb/K$^2$, in a range from 1.35 ppb/K$^2$ to 1.75 ppb/K$^2$, etc.). The slope of CTE of the substrate 14 is the rate of change of the CTE of the substrate 14 as a function of the temperature of the substrate 14. When the substrate 14 is utilized in EUV lithography applications, the slope of CTE is ideally minimized so that the substrate 14 experiences minimal thermal expansion caused by fluctuations in the temperature of the substrate 14 during the EUV lithography process. CTE slope is additionally measured by the technique disclosed in aforementioned United States Patent No. 10,458,936 as described above.

As used herein, the term "refractive index variation" means the maximal variation of refractive indices measured in a plane perpendicular to the optical axis of the sample of the substrate 14 along a predetermined direction. Refractive index was measured at room temperature using a Zygo interferometer operating at a wavelength of 633 nm (He-Ne laser). The sampling area of the measurement was 269 microns x 269 microns. For each sampling area, an average refractive index measurement over the full thickness of the sample was obtained. The sampling area was scanned across the full surface of the sample to obtain a series of local refractive index values that were used to determine the maximal variation of refractive index, which is defined as the difference between the maximum and minimum refractive index values obtained in the series of measurements. The samples for purposes of determining refractive index variation had dimensions of 15.24 cm (6 inches) x 15.24 cm (6 inches) x 0.64 cm (0.25 inch) (thickness), and is taken perpendicular to the intended optical axis. When measuring refractive index variation, the sample of the substrate 14 has a uniform thickness. Interferometry at about 633 nm (He-Ne laser) has been shown to be useful in providing maps of the refractive index variation across the sample. As is typically done by one skilled in the art, when discussing refractive index variation along a certain direction, tilt and piston are subtracted. Therefore, the refractive index variation along a certain direction (such as the radial direction of the sample) in the meaning of the present disclosure does not include tilt or piston. In preparation of the interferometry measurement, the sample of the substrate 14 is thermally stabilized. The surfaces of the substrate 14 are either polished or made transparent by utilizing index-matching oil. The surface shapes of all optics in the interferometer cavity and the refractive index variations of the sample will result in a total wavefront distortion measured by the interferometer. The refractive index variation is calculated as the difference between the highest refractive index and the lowest refractive index measured from the sample.

Refractive index variations correlate to $TiO_2$ concentration variations. In addition, variations in refractive index within the substrate 14 correlate with variations in CTE within the substrate 14. Thus, the higher the refractive index variation, the less uniformly the substrate 14 expands as the substrate 14 increases in temperature (and the less uniformly the substrate 14 contracts as the substrate 14 decreases in temperature).

In embodiments, the substrate 14, after the method 10, has a refractive index variation of 140 ppm or less. In embodiments, the substrate 14, after the method 10, has a refractive index variation of 60 ppm or less. In embodiments, the substrate 14, after the method 10, has a refractive index variation of 130 ppm or less, 120 ppm or less, 110 ppm or less, 100 ppm or less, 90 ppm or less, 80 ppm or less, 70 ppm or less, 60 ppm or less, 50 ppm or less, 40 ppm or less, or 30 ppm or less. In embodiments, the refractive index variation of the substrate 14 is 20 ppm to 140 ppm. In embodiments, the refractive index variation of the substrate 14 is 20 ppm, 30 ppm, 40 ppm, 50 ppm, 60 ppm, 70 ppm, 80 ppm, 90 ppm, 100 ppm, 110 ppm, 120 ppm, 130 ppm, 140 ppm, or within any range defined by any two of those values (e.g., 20 ppm to 60 ppm, 30 ppm to 110 ppm, etc.).

In embodiments, the substrate 14, after the method 10, has a concentration of OH groups of 600 ppm or greater, such as in a range from 600 ppm to 1400 ppm. In embodiments, the substrate 14, after the method 10, has a concentration of OH groups of 600 ppm, 700 ppm, 800 ppm, 900 ppm, 1000 ppm, 1100 ppm, 1200 ppm, 1300 ppm, 1400 ppm, or within any range bounded by any two of those values (e.g., in a range from 700 ppm to 1200 ppm, or in a range from 600 ppm to 1200 ppm). The concentration of OH groups as used herein is an average of the measurements taken of the sample. The hydroxyl (OH) groups can enter the substrate 14 during the step 68 of the method 10 that consolidates the molded precursor substrate 66 in the presence of steam to form the consolidated molded precursor substrate 70. The inclusion of the hydroxyl groups leads to a reduction in viscosity. The reduction in viscosity promotes more complete structural relaxation upon cooling and lowers the fictive temperature of the substrate 14. The fictive temperature of silica-titania glasses, like the substrate 14, is believed to correlate with the CTE slope. Low fictive temperatures lead to low CTE slopes. The concentration of OH groups in a sample of the substrate 14 is measured using Fourier-transform infrared ("FTIR") spectroscopy. The sample has a 6 mm path length and both major surfaces are polished, and the sample is cleaned with an organic solvent just before measurement. The OH group has characteristic absorption bands near 3600 cm$^{-1}$ and 4500 cm$^{-1}$ in glasses with high silica content. Transmittance near the peak of the 3600 cm$^{-1}$ absorption band is measured and ratioed with a reference transmittance (at a non-absorbing wavelength near 4000 cm$^{-1}$ to account for background intensity). The transmittance ratio is used in conjunction with the Beer-Lambert law to obtain the OH concentration. More specifically, the OH concentration, c, in mol·liter$^{-1}$, is derived from the Beer-Lambert Law,

$$A = \varepsilon \cdot c \cdot b$$

where the absorbance $A = \log \frac{T_{ref}}{T_{OH}}$, $\varepsilon$ is the molar absorptivity in liter·mol$^{-1}$·cm$^{-1}$, c is the concentration in mol·liter$^{-1}$, and b is the path length (sample thickness) in cm.

The concentration is thus

$$c(mol \cdot liter^{-1}) = A/(\varepsilon \cdot b)$$

The OH concentration in ppm by weight can thus be calculated from c in mol·liter$^{-1}$ using the density of the glass and molecular weight of OH. The constant $\varepsilon$ for high purity silica glass at a particular wavelength (such as ~3670 cm$^{-1}$) is available at K.M. Davis, et al, "Quantitative infrared spectroscopic measurement of hydroxyl concentration in silica glass," J. Non-Crystalline Solids, 203 (1996) 27-36.

In embodiments, the substrate 14, after the method 10, further comprises a hardness in a range from 4.60 GPa to 4.75 GPa. In embodiments, the hardness is 4.60 GPa, 4.61 GPa, 4.62 GPa, 4.63 GPa, 4.64 GPa, 4.65 GPa, 4.66 GPa, 4.67 GPa, 4.68 GPa, 4.69 GPa, 4.70 GPa, 4.71 GPa, 4.72 GPa, 4.73 GPa, 4.74 GPa, 4.75 GPa, or within any range bounded by any two of those values (e.g., in a range from 4.62 GPa to 4.73 GPa, in a range from 4.61 GPa to 4.69 GPa, etc.). For purposes of this disclosure, hardness is determined via ASTM C730, titled Standard Test Method for Knoop Indentation Hardness of Glass." Hardness was measured using a load of 200 g and measurements were made at five positions along the sample. The sample was 30 mm x 50 mm x 4 mm. The measurements were taken near the center of the sample, at a spacing between measurements of 200 $\mu$m to 500 $\mu$m. The results of the five measurements were averaged to obtain the hardness of the sample. As discussed further below, the method 10 surprisingly results in the substrate 14 having this characteristic hardness range that is lower than the hardness of substrates of a similar composition but made via different processes such as the direct-to-glass method described in the Background. Because of the lower hardness, the substrate 14 can be more effectively polished leaving a surface with reduced irregularities, thus allowing for smaller wavelengths to be utilized during EUV lithography to replicate narrower linewidths onto the silicon wafer. Without being bound by theory, it is believed that the decreased hardness may be a consequence of the carbon monoxide and carbon dioxide molecules diffusing or dissolving into the glass, which is a result of the step 12 of the method 10.

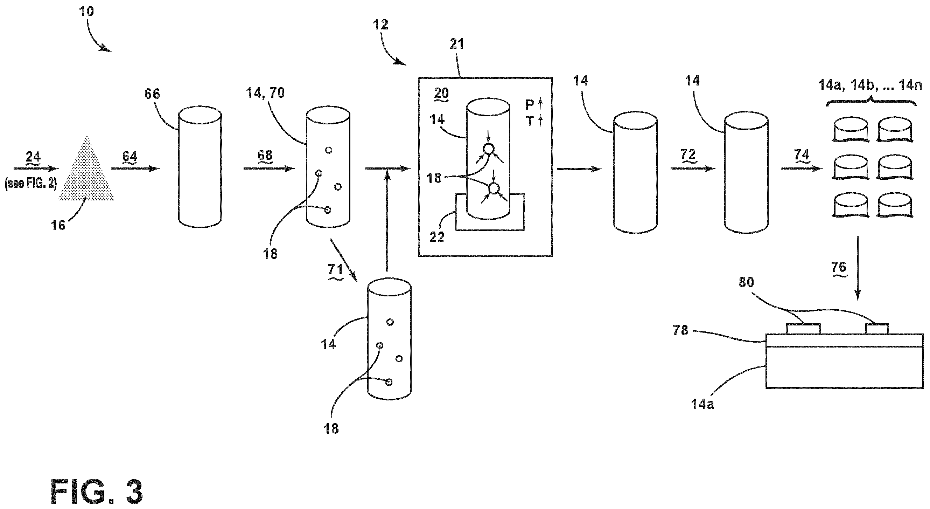

In embodiments, the method 10 further comprises, at a step 74 and after subjecting the substrate 14 to the environment 20 at the step 12 and annealing the substrate 14 at the step 72, slicing the substrate 14 into the plurality of substrates 14a, 14b, ... 14n (see FIG. 3). In embodiments, each of the plurality of substrates 14a, 14b, ... 14n has a mass of 100 grams to 1 kilogram, and 0.05 gas inclusions 18, or less, per 16.4 cm$^3$ (cubic inch), such as in a range from 0.01 gas inclusions 18 per 16.4 cm$^3$ (cubic inch) to 0.49 gas inclusions 18 per 16.4 cm$^3$ (cubic inch). In embodiments, each of the plurality of substrates 14a, 14b, ... 14n has a mass of 500 grams to 1 kilogram, and no gas inclusions 18. In embodiments, each of the plurality of substrates 14a, 14b, ... 14n has (i) a mass of 100 grams, 200 grams, 300 grams, 400 grams 500 grams, 600 grams, 700 grams, 800 grams, 900 grams, 1 kg, or within any range bounded by any two of those values (e.g., in a range from 100 grams to 700 grams, in a range from 200 grams to 900 grams, etc.), and (ii) 0.05 gas inclusions 18, or less, per 16.4 cm$^3$ (cubic inch), such as 0.01 gas inclusions 18 per 16.4 cm$^3$ (cubic inch) or less, or no gas inclusions 18. When the substrate 14, before being sliced into the plurality of substrates 14a, 14b, . . 14n, has about 0.06 gas inclusions 18 per 16.4 cm$^3$ (cubic inch), approximately fifty percent of the plurality of substrates 14a, 14b, ... 14n sliced therefrom (assuming eight total) would have no gas inclusions 18, assuming random distribution of the gas inclusions 18. When the substrate 14, before being sliced into the plurality of substrates 14a, 14b, ... 14n, has about 0.01 gas inclusions 18 per 16.4 cm$^3$ (cubic inch), approximately 87.5 percent of the plurality of substrates 14a, 14b, ... 14n sliced therefrom (assuming eight total) would have no gas inclusions 18, assuming random distribution of the gas inclusions 18. And of course, when the substrate 14, before being sliced into the plurality of substrates 14a, 14b, ... 14n, has about no gas inclusions 18 per 16.4 cm$^3$ (cubic inch), all of the plurality of substrates 14a, 14b, ... 14n sliced therefrom would have no gas inclusions 18.

Each of the plurality of substrates 14a, 14b, ... 14n has the CTE, the crossover temperature, the slope of CTE, the refractive index variation, the concentration of OH groups, the hardness, and the compositional properties discussed above for the substrate 14 from which the plurality of substrates 14a, 14b, ... 14n were sliced. With such a mass and so few gas inclusions 18 per 16.4 cm$^3$ (cubic inch), or no gas inclusions 18 at all, each of the plurality of substrates 14a, 14b, ... 14n is suitable for use in EUV lithography as a mirror or photomask. Thus, the above method 10 and resulting substrate 14 (and the plurality of substrates 14a, 14b, ... 14n) represent a great improvement over previous attempts. When the substrate 14 has a mass of about 6 kg, the step of slicing the substrate 14 can yield about 7 or 8 substrates 14a, 14b, ... 14n that are appropriately sized for application as a EUV photomask.

In embodiments, the method 10 further comprises a step 76 applying a reflective multilayer film 78 on the substrate 14, or at least one of the plurality of substrates 14a, 14b, ... 14n, and, in embodiments, forming an absorber 80 on the reflective multilayer film 78 (see FIG. 3). The multilayer film 78 can comprise layers of molybdenum and silicon, or molybdenum and beryllium, as known in the EUV lithography art. The layers of reflective multilayer film 78 can be applied via magnetron sputtering or other suitable technique. The absorber 80 defines the pattern to be replicated on the wafer during the EVU lithography process. In embodiments where the reflective multilayer film 78 is applied to the substrate, the reflective multilayer film 78 can be applied after or before subjecting the substrate 14 to the environment 20 at the step 12. The substrate 14 with the reflective multilayer film 78 and the absorber 80 can then be sliced at the step 74 into the plurality of substrates 14a, 14b, ... 14n, each of the plurality of substrates 14a, 14b, ... 14n thus including the multilayer film 74 and the absorber 80.

EXAMPLES

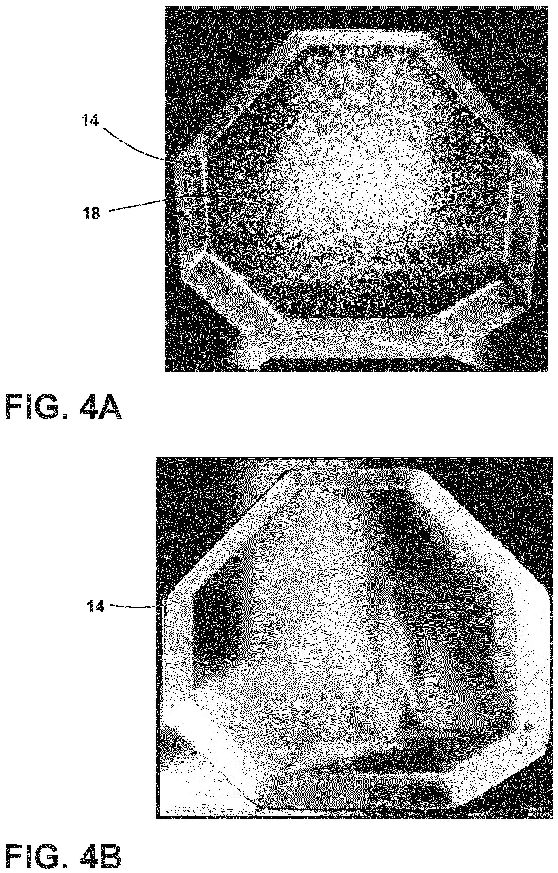

Example 1 - For Example 1, a substrate was formed from soot particles comprising SiO$_2$ and TiO$_2$, including the steps of forming the soot particles, collecting the soot particles that were formed, molding the collected soot particles at room temperature into a molded precursor substrate, heat treating the molded precursor substrate in the presence of steam forming a consolidated precursor substrate, and then melting the consolidated precursor substrate within a graphite mold, which upon cooling and removing the graphite mold, formed the substrate. The silica precursor utilized during the forming of the soot particles was of octamethylcyclotetrasiloxane, and the titania precursor was titanium isopropoxide. The soot particles were collected from collection chambers disposed below filter bags. As illustrated in FIG. 4A, the substrate comprised a high quantity of gas inclusions (greater than 1 gas inclusion per 16.4 $cm^3$ (cubic inch)).

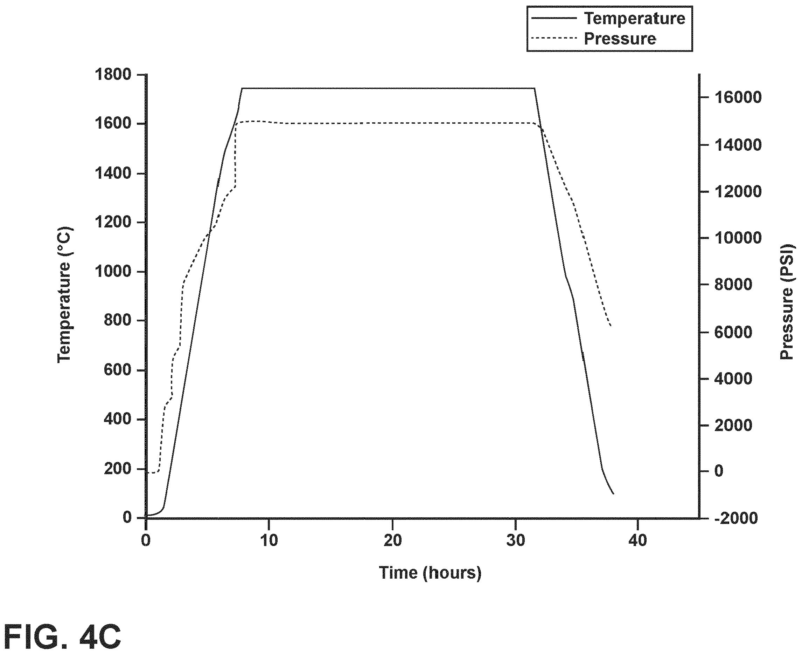

The substrate was subsequently subjected to an environment having an elevated temperature of 1750 °C and an elevated pressure of 103421.4 kPa (15 kpsi) for a period of time of 24 hours in a high pressure containment vessel. Argon was utilized to provide the elevated pressure. Before the 24 hour period of time began, the temperature of the environment (with the substrate within the environment) increased from room temperature to 1750 °C at a temperature increase rate as indicated at the graph reproduced at FIG. 4C. Likewise, after the 24 hour period of time ended, the temperature of the environment (with the substrate within the environment) decreased from 1750 °C to room temperature at a temperature decrease rate as also indicated at the graph reproduced at FIG. 4C.

As a consequence, the substrate comprised less than 0.05 gas inclusion per 16.4 $cm^3$ (cubic inch). More specifically, the substrate comprised no gas inclusions, as the depiction of the substrate at FIG. 4B shows. Subjecting the substrate to the elevated temperature and the elevated pressure caused the numerous gas inclusions that existed before the subjecting step to collapse.

Examples 2A-3D - For these examples, loose soot particles comprising $SiO_2$ and $TiO_2$ were formed in two separate batches - one for Examples 2A-2C, and one for Examples 3A-3D. The loose soot particles for each batch were then collected. The flowrate of the titania precursor relative to the flow rate of the silica precursor was slightly higher for the batch from which Examples 2A-2D derived compared to the batch from which Examples 3A-3D derived. The result was that Examples 2A-2C had a composition comprising 7.67 mol% $TiO_2$, while Examples 3A-3D had a composition comprising 7.61 mol% $TiO_2$. The loose soot particles from each batch were then molded into two separate molded precursor substrates. Each molded precursor substrate was then heat treated in the presence of steam during a consolidation step, forming two separate substrates - one for Examples 2A-2C, and one for Examples 3A-3D. Both substrates had a high amount of gas inclusions (e.g., greater than 1 gas inclusion per 16.4 $cm^3$ (cubic inch)).

Each of the two substrates was then subjected to the environment having the elevated temperature and the elevated pressure, for a period of time, to address the gas inclusions. Neither of the two substrates was subjected to the step of melting before being subjected to the elevated temperature and the elevated pressure to address the gas inclusions. The substrate from which Examples 2A-2C were taken was subjected to an elevated temperature of 1700 °C and an elevated pressure of 100 atm (~1.47 kpsi) for a period of time of 10 hours. In contrast, the substrate from which Examples 3A-3D were taken was subjected to an elevated temperature of 1700 °C and an elevated pressure of 1000 atm (~14.7 kpsi) for a period of time of 10 hours. In other words, the elevated temperature of 1700 °C and the period of time of 10 hours remained constant, while the elevated pressure was different for each of the two substrates (100 atm versus 1000 atm). The elevated temperature and the elevated pressure virtually eliminated the gas inclusions present in each substrate.

Each substrate was then sliced into a plurality of substrates, from which Examples 2A-2C and Examples 3A-3D were selected. The concentrations of OH groups for Examples 2A, 2B, 3A, and 3B were measured and calculated via the procedure described above. Examples 2A and 2B had an OH group concentration of about 820 ppm. Examples 3A and 3B had an OH group concentration of about 1090 ppm.

The plurality of substrates representing Examples 2A-3D were then annealed. Examples 2A, 2B, 3A, 3B were annealed pursuant to one set of common conditions referred to as "Cycle 1." Examples 2C, 3C, 3D were annealed pursuant to another set of common conditions, referred to as "Cycle 2," which is different than Cycle 1. Cycle 1 takes less total time and has a higher highest temperature that Cycle 2.

The CTE, Tzc, and slope of CTE were determined for each of the Examples according to the techniques explained above. TABLE 1 below lists the results. An analysis of the results reveals that higher OH group concentration causes the substrate to have a lower CTE, Tzc, and slope of CTE. In addition, the longer Cycle 2 anneal results in a significantly lower CTE, Tzc, and slope of CTE.

| TABLE 1 | | | | | | |
|---|---|---|---|---|---|---|
| Example | OH-group concentration (ppm) | Elevated Pressure | CTE (ppb/K) | Tzc (°C) | Slope of CTE (ppb/K$^2$) | Anneal |
| 2A | ~820 | 100 atm (~1.47 kpsi) | -40.39 | 51.2 | 1.62 | Cycle 1 |
| 2B | ~820 | 100 atm (~1.47 kpsi) | -40.76 | 51.2 | 1.63 | Cycle 1 |

(continued)

| Example | OH-group concentration (ppm) | Elevated Pressure | CTE (ppb/K) | Tzc (°C) | Slope of CTE (ppb/K$^2$) | Anneal |
|---|---|---|---|---|---|---|
| 2C | ~820 | 100 atm (~1.47 kpsi) | -12.76 | 30.1 | 1.36 | Cycle 2 |
| 3A | ~1090 | 1000 atm (~14.7 kpsi) | -29.27 | 41.2 | 1.60 | Cycle 1 |
| 3B | ~1090 | 1000 atm (~14.7 kpsi) | -27.27 | 41.8 | 1.49 | Cycle 1 |
| 3C | ~1090 | 1000 atm (~14.7 kpsi) | 3.79 | 17.1 | 1.27 | Cycle 2 |
| 3D | ~1090 | 1000 atm (~14.7 kpsi) | 1.81 | 18.6 | 1.31 | Cycle 2 |

Examples 4A-4D and Comparative Examples 4E and 4F - For Examples 4A-34 and Comparative Example 4E, loose soot particles comprising $SiO_2$ and $TiO_2$ were formed in a single batch. The weight percentage of TiO2 in the soot particles was 7.5 % to 7.7 %. The loose soot particles for each batch were then collected, molded into a molded precursor substrate, heat treated in the presence of steam during a consolidation step, and then melted to form the substrate. The substrate was then subjected to the environment having the elevated temperature and the elevated pressure, for a period of time, to remove gas inclusions. The substrate was then sliced into five samples representing Examples 4A-4D, and Comparative Example 4E. Each sample had dimensions of approximately 50 mm x 50 mm x 4 mm.

The samples of Examples 4A and 4B were subjected to an elevated temperature of 1700 °C and an elevated pressure of 100 atm (~1.47 kpsi) for a period of time of 10 hours. In contrast, the samples of Examples 4C and 4D were subjected to an elevated temperature of 1700 °C and an elevated pressure of 1000 atm (~14.7 kpsi) for a period of time of 10 hours. In other words, the elevated temperature of 1700 °C and the period of time of 10 hours remained constant, while the elevated pressure was different for each pair of substrates (100 atm versus 1000 atm). The elevated temperature and the elevated pressure virtually eliminated the gas inclusions present in each of the samples representing Examples 4A-4D. The sample of Comparative Example 4E was not subjected to an elevated temperature and elevated pressure to address gas inclusions. The samples of all of Examples 4A-4D and Comparative Example 4E were then annealed according to Cycle #1 mentioned above, that takes less time than Cycle #2 and has a higher maximum temperature.

For Comparative Example 4F, loose soot particles were not formed and then compressed according to the method described above. Rather, for Comparative Example 4F, an OVD (overhead vapor deposition) process was used in which a soot blank is made in a burner by the combustion of a silica precursor and a titania precursor, and the resulting soot is collected on a mandrel, consolidated, and collected to form a glass boule in a direct-to-glass process. The glass boule was then annealed according to Cycle # 1.

The hardness of each of the samples was then measured via the technique described above. TABLE 2 below sets forth the data. As analysis data reveals, the samples of Examples 4A-4D that were formed via the collection and pressing of loose soot and then subjected to the elevated temperature and the elevated pressure to address gas inclusions had a characteristic hardness between 4.60 GPa and 4.75 GPa that was lower than the hardness (4.98 GPa) of the sample of Comparative Example 4E that was formed via the collection and pressing of loose soot but not subjected to the elevated temperature and the elevated pressure to address gas inclusions. In addition, the samples of Examples 4A-4D that were formed via the collection and pressing of loose soot and then subjected to the elevated temperature and the elevated pressure to address gas inclusions had a characteristic hardness between 4.60 GPa and 4.75 GPa that was lower than the hardness (4.83 GPa) of the sample of Comparative Example 4F that was formed via the "direct-to-glass" process described in the Background and also not subjected to the elevated temperature and the elevated pressure to gas inclusions. The method described herein thus results in a substrate with a characteristic hardness in a range from 4.60 GPa to 4.75 GPa that is lower than substrates of a similar composition but made via different processes. It is believed that the samples of Examples 4A-4D, if annealed according to Cycle #2 described above rather than Cycle #1, would have had the same hardness in a range from 4.60 GPa to 4.75 GPa.

| TABLE 2 | | | | |
|---------|---|---|---|---|
| Example | Elevated Temp and Pressure? | Loose Soot Collected and Pressed? | Elevated Pressure (atm) | Hardness (GPa) |
| 4A | Yes | Yes | 100 | 4.72 |
| 4B | Yes | Yes | 100 | 4.68 |
| 4C | Yes | Yes | 1000 | 4.65 |
| 4D | Yes | Yes | 1000 | 4.73 |
| Comp. 4E | No | Yes | --- | 4.98 |
| Comp. 4F | No | No | --- | 4.83 |

<u>Examples 5A-5D</u> - For Examples 5A-5D, loose soot particles comprising $SiO_2$ and $TiO_2$ were formed in three different batches. The loose soot particles for each batch were then collected, molded into a molded precursor substrate, heat treated in the presence of steam during a consolidation step, and then melted to form the substrate. Each substrate was then subjected to the environment having the elevated temperature and the elevated pressure, for a period of time, to remove gas inclusions. The substrate from which the samples of Examples 5A and 5B would be sliced was subjected to the elevated pressure of 100 atm (~1.5 kpsi) and the elevated temperature of 1700 °C for 10 hours. The substrate from which the sample of Example 5C would be sliced was subjected to the elevated pressure of 1000 atm (~15 kpsi) and the elevated temperature of 1700 °C for 10 hours. The substrate from which the sample of 5D would be sliced was subjected to the elevated pressure of 100 atm (~1.5 kpsi) and the elevated temperature of 1750 °C for 10 hours. Each substrate was then annealed according to Cycle #2 above. The four different substrates from each batch were then sliced into samples representing Examples 5A-5D. Samples representing Examples 5A and 5B were sliced from the same substrate. The samples representing 5C and 5D were sliced from two different samples (each resulting from a different batch). After slicing, the dimensions of each sample was approximately 143 mm x 150 mm x 7.4 mm.

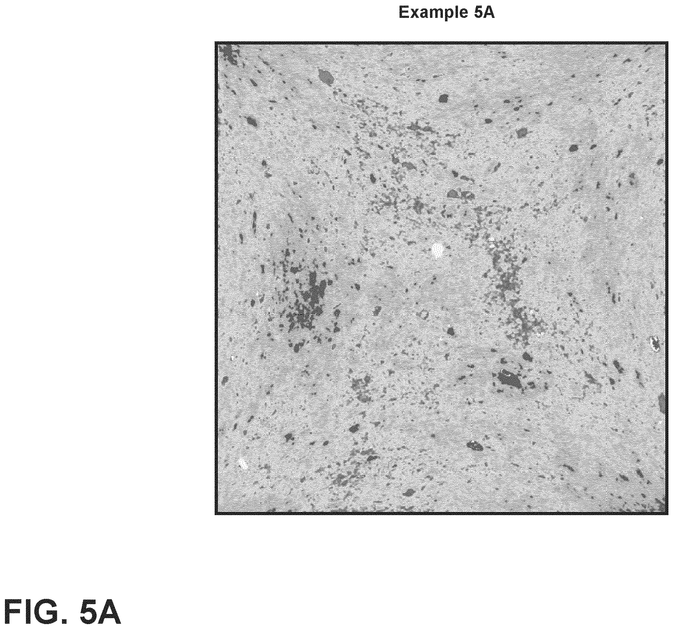

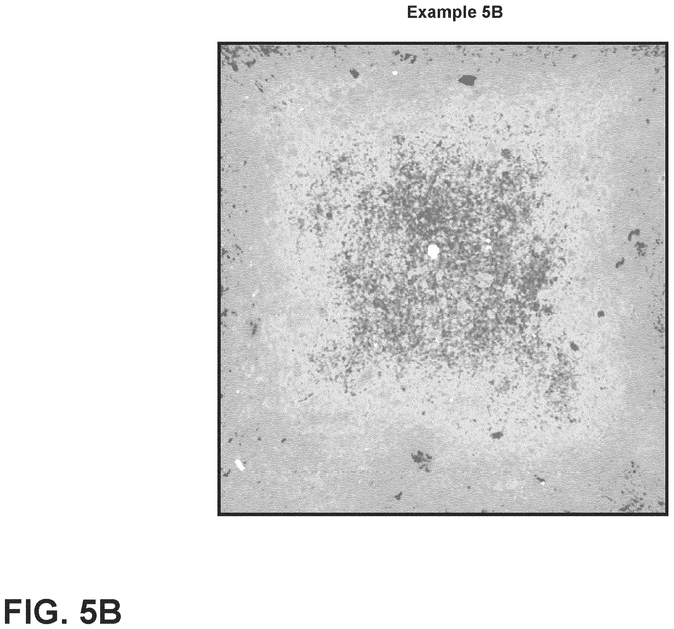

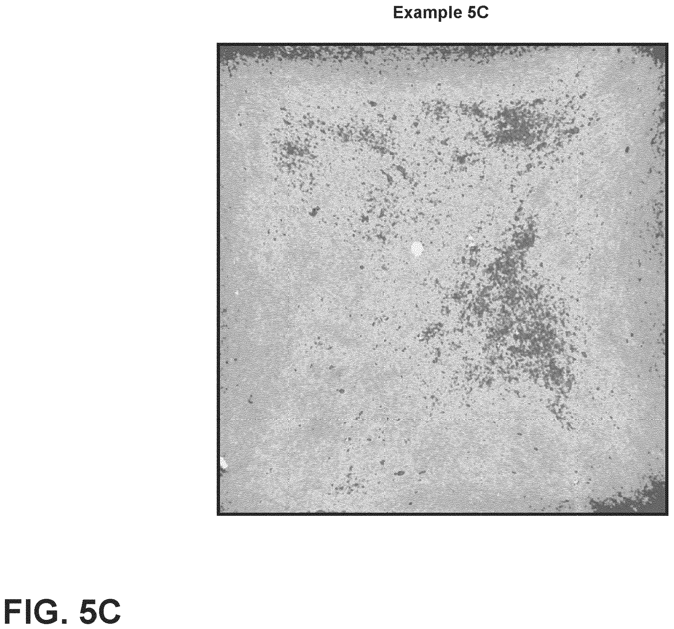

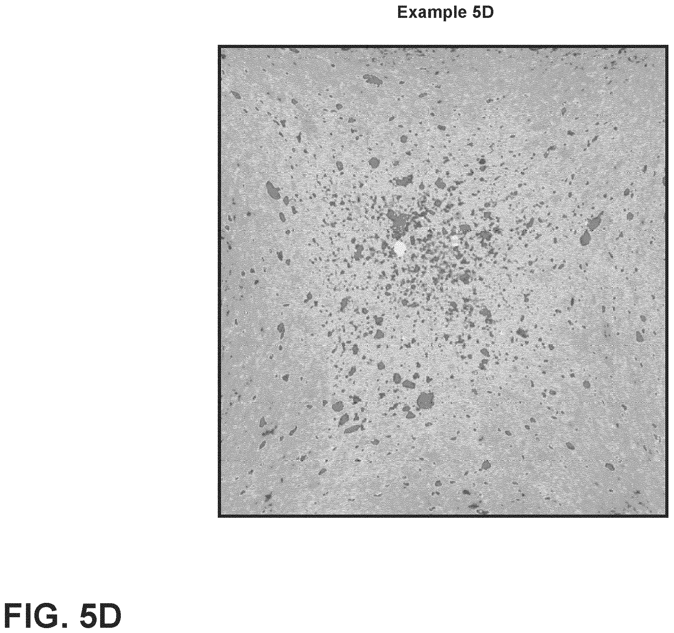

The refractive index variations of each of the samples representing Examples 5A-5D were then measured via the interferometry technique (He-Ne laser) described above. The data is set forth in the TABLE 3 below. Maps of the refractive index variation for each of the Examples 5A-5D are reproduced at FIGS. 5A-5D. Analysis of the data of TABLE 3 reveals that (i) higher pressure causes lower refractive index variation, (ii) higher temperature causes lower refractive index variation, and (iii) refractive index variation can change as a function of position along the substrate (Example 5A versus Example 5B).

| TABLE 3 | | | | |
|---------|---|---|---|---|
| Example | Elevated Pressure (atm) | Elevated Temperature (°C) | Refractive Index Variation (ppm) | Representative Figure |
| 5A | 100 | 1700 | 56.52 | 5A |
| 5B | 100 | 1700 | 27.72 | 5B |
| 5C | 1000 | 1700 | 20.16 | 5C |
| 5D | 100 | 1750 | 46.81 | 5D |

**Claims**

1. A silica-titania glass substrate comprising:

   a composition comprising 5 weight percent to 10 weight percent $TiO_2$;
   a coefficient of thermal expansion (CTE) at 20 °C in a range from -45 ppb/K to +20 ppb/K;
   a crossover temperature (Tzc) in a range from 10 °C to 50 °C;
   a slope of CTE at 20 °C in a range from 1.20 $ppb/K^2$ to 1.75 $ppb/K^2$;
   a refractive index variation of 140 ppm or less; and
   a concentration of OH groups of 600 ppm or greater.

2. The silica-titania glass substrate of claim 1, further comprising:

a mass of 1 kg or greater; and
0.05 gas inclusions, or less, per 16.4 $cm^3$ (cubic inch),
or
a mass in a range from 100 grams to 1 kg; and
0.05 gas inclusions, or less, per 16.4 $cm^3$ (cubic inch).

3. The silica-titania glass substrate of any one of claims 1-2, further comprising 0.01 gas inclusions, or less, per 16.4 $cm^3$ (cubic inch) or further comprising no gas inclusions.

4. The silica-titania glass substrate of any one of claims 1-3 with one or more of the following:

- wherein the composition further comprises 0.001 to 0.01 weight percent carbon;
- further comprising one or more solid inclusions that comprise one or more of iron, chromium, zirconium, an oxide of iron, an oxide of chromium, an oxide of zirconium, and cristobalite;
- further comprising a hardness in a range from 4.60 GPa to 4.75 GPa;
- wherein the crossover temperature (Tzc) is in a range from 20 °C to 38 °C;
- wherein the crossover temperature (Tzc) is in a range from 22 °C to 38 °C;
- wherein the slope of CTE at 20 °C is in a range from 1.30 $ppb/K^2$ to 1.65 $ppb/K^2$;
- wherein the refractive index variation is 60 ppm, or less;
- wherein the refractive index variation is in a range from 20 ppm to 60 ppm;
- wherein the concentration of OH groups is in a range from 600 ppm to 1400 ppm;
- wherein the concentration of OH groups is in a range from 700 ppm to 1200 ppm.

5. A method comprising:
subjecting a substrate (i) formed from soot particles, each of the soot particles comprising $SiO_2$ and $TiO_2$, and (ii) comprising greater than or equal to 0.05 gas inclusions per 16.4 $cm^3$ (cubic inch), to an environment having an elevated temperature and an elevated pressure for a period of time until the substrate comprises 0.05 gas inclusions, or less, per 16.4 $cm^3$ (cubic inch).

6. The method of claim 5, further comprising one or more of the following:

- before subjecting the substrate to the environment, (i) forming the soot particles as loose soot particles, and (ii) collecting the soot particles;
- before subjecting the substrate to the environment, (i) molding the soot particles at room temperature into a molded precursor substrate having a predetermined density in a range from 0.50 $g/cm^3$ to 1.20 $g/cm^3$, and (ii) heat treating the molded precursor substrate in the presence of steam, forming the substrate, wherein, the substrate is opaque following the step of heat treating the molded precursor substrate.
- before subjecting the substrate to the environment, (i) molding the soot particles at room temperature into a molded precursor substrate having a predetermined density in a range from 0.50 $g/cm^3$ to 1.20 $g/cm^3$, (ii) heat treating the molded precursor substrate in the presence of steam, thus forming a consolidated molded precursor substrate, and (iii) melting the consolidated precursor substrate into a melt that flows into a mold, thus, upon subsequent cooling, forms the substrate, wherein, the elevated temperature of the environment of the subjecting step is in a range from 1000 °C to 1150 °C, preferably wherein heat treating the molded precursor substrate in the presence of steam comprises subjecting the molded precursor substrate to a consolidation environment into which steam is introduced to achieve a pressure within the consolidation environment in a range from 0.1 atm to 10 atm.

7. The method of any one of claims 5-6, further comprising:
after subjecting the substrate to the environment, annealing the substrate for at least 100 hours with a maximum temperature in a range from 900 °C to 1200 °C.

8. The method of any one of claims 5-7, further comprising:

after subjecting the substrate to the environment, slicing the substrate into a plurality of substrates, each of the plurality of substrates having a mass in a range from 100 grams to 1 kg, preferably wherein
each of the plurality of substrates comprise 0.01 gas inclusions, or less, per 16.4 $cm^3$ (cubic inch) or wherein
each of the plurality of substrates comprise no gas inclusions.

**9.** The method of claim 8, further comprising:
applying a reflective multilayer film on at least one of the plurality of substrates; and forming an absorber on the reflective multilayer film.

**10.** The method of any one of claims 5-9 with one or more of the following:

- wherein before subjecting the substrate to the environment, the gas inclusions comprise one or more of CO and $CO_2$, preferably
wherein before subjecting the substrate to the environment, the gas inclusions comprise at least 70 mole percent combined of CO and $CO_2$;
- wherein the environment having the elevated temperature and the elevated pressure comprises an inert gas;
- wherein the elevated temperature is in a range from 1000 °C to 1800 °C;
- wherein the elevated pressure is in a range from 3447.4 kPa to 103421.4 kPa (0.5 kpsi to 15 kpsi);
- wherein the period of time is at least 1 hour;
- wherein before the period of time begins and while the substrate is in the environment, a temperature of the environment is increased from room temperature to the elevated temperature at a temperature increase rate in a range from 125 °C/hr to 500 °C/hr;
- wherein after the period of time ends and while the substrate is in the environment, the temperature of the environment is decreased from the elevated temperature to room temperature at a temperature decrease rate in a range from 125 °C/hr to 500 °C/hr;
- wherein

the elevated pressure is in a range from 8963.2 kPa to 11721.1 kPa (1.3 kpsi to 1.7 kpsi); the elevated temperature is in a range from 1650 °C to 1800 °C; and
the period of time is in a range from 8 hours to 12 hours;
before the period of time begins and while the substrate is in the environment, a temperature of the environment is increased from room temperature to the elevated temperature at a temperature increase rate in a range from 250 °C/hr to 350 °C/hr; and after the period of time ends and while the substrate is in the environment, the temperature of the environment is decreased from the elevated temperature to room temperature at a temperature decrease rate in a range from 250 °C/hr to 350 °C/hr;

- wherein during the subjecting the substrate to the environment, a support comprising graphite supports the substrate.

**11.** The method of any one of claims 5-10, wherein

after subjecting the substrate to the environment, the substrate comprises:

(i) a composition comprising 5 weight percent to 10 weight percent $TiO_2$;
(ii) a coefficient of thermal expansion (CTE) at 20 °C in a range from -45 ppb/K to +20 ppb/K;
(iii) a crossover temperature (Tzc) in a range from 10 °C to 50 °C;
(iv) a slope of CTE at 20 °C in a range from 1.20 ppb/K$^2$ to 1.75 ppb/K$^2$;
(v) a refractive index variation of 140 ppm, or less; and
(vi) a concentration of OH groups of 600 ppm or greater,
preferably wherein

after subjecting the substrate to the environment, the substrate comprises: a hardness in a range from 4.60 GPa to 4.75 GPa, and/or wherein
the crossover temperature (Tzc) is in a range from 20 °C to 38 °C;
the slope of CTE at 20 °C is in a range from 1.30 ppb/K$^2$ to 1.65 ppb/K$^2$;
the refractive index variation is in a range from 20 ppm to 60 ppm; and
the concentration of OH groups is in a range from 600 ppm to 1400 ppm.

**12.** The method of any one of claims 5-11, wherein

the substrate further comprises a mass of 1 kg or greater; and
after subjecting the substrate to the environment, the substrate further comprises 0.05 gas inclusions, or less, per 16.4 cm$^3$ (cubic inch) or

wherein

after subjecting the substrate to the environment, the substrate further comprises no gas inclusions.

**13.** The method of any one of claims 5-12, further comprising:

applying a reflective multilayer film on the substrate and forming an absorber on the reflective multilayer film.

**14.** A method comprising:

forming soot particles comprising $SiO_2$ and $TiO_2$ as loose soot particles;

collecting the soot particles;

molding the soot particles into a molded precursor substrate;

heat treating the molded precursor substrate in the presence of steam, forming a substrate, the substrate comprising greater than or equal to 0.05 gas inclusion per 16.4 cm$^3$ (cubic inch); and

subjecting the substrate to an environment having an elevated temperature in a range from 1000 °C to 1800 °C and an elevated pressure in a range from 3447.4 kPa to 103421.4 kPa (0.5 kpsi to 15 kpsi) for a period of time in a range from 1 hour to 120 hours until the number of the gas inclusions per 16.4 cm$^3$ (cubic inch) has reduced to 0.05 gas inclusions, or less, per 16.4 cm$^3$ (cubic inch).

**15.** The method of claim 14, wherein

before the predetermined period of time begins, a temperature of the environment is increased from room temperature to the elevated temperature in the presence of the substrate at a temperature increase rate in a range from 125 °C/hr to 500 °C/hr; and

after the predetermined period of time ends, the temperature of the environment is decreased from the elevated temperature to room temperature in the presence of the substrate at a temperature decrease rate in a range from 125 °C/hr to 500 °C/hr,

and/or

wherein, after the substrate is subjected to the environment, the substrate comprises:

a composition comprising 5 weight percent to 10 weight percent $TiO_2$;

a coefficient of thermal expansion (CTE) at 20 °C in a range from -45 ppb/K to +20 ppb/K;

a crossover temperature (Tzc) in a range from 10 °C to 50 °C;

a slope of CTE at 20 °C in a range from 1.20 ppb/K$^2$ to 1.75 ppb/K$^2$;

a refractive index variation of 140 ppm or less;

a concentration of OH groups of 600 ppm or greater; and

a hardness in a range from 4.60 GPa to 4.75 GPa.

10

```
      ┌─────────────────────────┐
      │            24           │
      └─────────────────────────┘
                   │
                   ▼
      ┌─────────────────────────┐
      │            64           │
      └─────────────────────────┘
                   │
                   ▼
      ┌─────────────────────────┐
      │            66           │
      └─────────────────────────┘
                   │
                   ▼
      ┌─────────────────────────┐
      │            68           │
      └─────────────────────────┘
                   │
                   ▼
      ┌─────────────────────────┐
      │            71           │
      └─────────────────────────┘
                   │
                   ▼
      ┌─────────────────────────┐
      │            12           │
      └─────────────────────────┘
                   │
                   ▼
      ┌─────────────────────────┐
      │            72           │
      └─────────────────────────┘
                   │
                   ▼
      ┌─────────────────────────┐
      │            74           │
      └─────────────────────────┘
                   │
                   ▼
      ┌─────────────────────────┐
      │            76           │
      └─────────────────────────┘
```

FIG. 1

FIG. 2

**FIG. 3**

14
18

**FIG. 4A**

14

**FIG. 4B**

FIG. 4C

EP 4 039 660 A1

Example 5A

FIG. 5A

Example 5B

FIG. 5B

Example 5C

FIG. 5C

Example 5D

FIG. 5D

Europäisches Patentamt

European Patent Office

Office européen des brevets

**EUROPEAN SEARCH REPORT**

Application Number

EP 22 15 4230

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2011/207593 A1 (DURAN CARLOS [CA] ET AL) 25 August 2011 (2011-08-25) * the whole document * * in particular examples 1-2, figures 1-4 and claims 1-5 * ----- | 1-15 | INV. C03C3/06 C03C4/00 C03C23/00 G03F7/00 C03B32/00 C03B20/00 C03C17/36 |
| Y | US 5 410 428 A (YAMAGATA SHIGERU [JP] ET AL) 25 April 1995 (1995-04-25) * the whole document * * in particular examples  and figure 1 * ----- | 1-15 | |
| Y | WO 98/07053 A2 (CORNING INC [US]; SEWARD THOMAS P III [US]) 19 February 1998 (1998-02-19) * the whole document * * in particular examples * ----- | 1-15 | |
| Y | US 2009/104454 A1 (SAYCE IAN GEORGE [GB]) 23 April 2009 (2009-04-23) * the whole document * * in particular examples and claims 1-15 * ----- | 1-15 | |

TECHNICAL FIELDS SEARCHED (IPC)

C03C
G03F
C03B

The present search report has been drawn up for all claims

| Place of search | Date of completion of the search | Examiner |
|---|---|---|
| Munich | 28 March 2022 | Heer, Stephan |

EPO FORM 1503 03.82 (P04C01)

## ANNEX TO THE EUROPEAN SEARCH REPORT
## ON EUROPEAN PATENT APPLICATION NO.

EP 22 15 4230

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2022

| Patent document cited in search report | | Publication date | Patent family member(s) | | Publication date |
|---|---|---|---|---|---|
| US 2011207593 | A1 | 25-08-2011 | EP | 2385024 A1 | 09-11-2011 |
| | | | JP | 2012046406 A | 08-03-2012 |
| | | | US | 2011207593 A1 | 25-08-2011 |
| US 5410428 | A | 25-04-1995 | AT | 135669 T | 15-04-1996 |
| | | | DE | 69118101 T2 | 19-09-1996 |
| | | | EP | 0483752 A2 | 06-05-1992 |
| | | | US | 5410428 A | 25-04-1995 |
| WO 9807053 | A2 | 19-02-1998 | EP | 0914301 A2 | 12-05-1999 |
| | | | JP | 2001511105 A | 07-08-2001 |
| | | | KR | 20000029593 A | 25-05-2000 |
| | | | US | 6205818 B1 | 27-03-2001 |
| | | | US | 2001011465 A1 | 09-08-2001 |
| | | | WO | 9807053 A2 | 19-02-1998 |
| US 2009104454 | A1 | 23-04-2009 | CN | 101426740 A | 06-05-2009 |
| | | | EP | 1996523 A1 | 03-12-2008 |
| | | | JP | 2009530217 A | 27-08-2009 |
| | | | KR | 20090039668 A | 22-04-2009 |
| | | | US | 2009104454 A1 | 23-04-2009 |
| | | | WO | 2007107709 A1 | 27-09-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10458936 B

**Non-patent literature cited in the description**

- **J. NOLTE.** ICP Emission Spectrometry: A Practical Guide. Wiley-VCH, 2003
- **H. E. TAYLOR.** Inductively Coupled Plasma Mass Spectroscopy: Practices and Techniques. Academic Press, 2000
- **S. J. B. REED.** Electron Microprobe Analysis. Cambridge University Press, 1997
- **K.M. DAVIS et al.** Quantitative infrared spectroscopic measurement of hydroxyl concentration in silica glass. *J. Non-Crystalline Solids,* 1996, vol. 203, 27-36